(19) Europäisches Patentamt
European Patent Office
Office européen des brevets

(11) EP 1 517 379 A2

(12) EUROPEAN PATENT APPLICATION

(43) Date of publication:
23.03.2005 Bulletin 2005/12

(21) Application number: 04008437.8

(22) Date of filing: 07.04.2004

(51) Int Cl.7: H01L 33/00, H01S 5/327

(84) Designated Contracting States:
AT BE BG CH CY CZ DE DK EE ES FI FR GB GR HU IE IT LI LU MC NL PL PT RO SE SI SK TR
Designated Extension States:
AL HR LT LV MK

(30) Priority: 19.09.2003 JP 2003328088
20.11.2003 JP 2003390261
01.12.2003 JP 2003401557
01.12.2003 JP 2003401560

(71) Applicant: SUMITOMO ELECTRIC INDUSTRIES, LTD.
Osaka-shi, Osaka (JP)

(72) Inventors:
- Fujiwara, Shinsuke
1-1-3 Shimaya Konohanaku
Osaka-shi Osaka (JP)
- Nakamura, Takao
1-1-3 Shimaya Konohanaku
Osaka-shi Osaka (JP)
- Mori, Hiroki
1-1-3 Shimaya Konohanaku
Osaka-shi Osaka (JP)
- Katayama, Koji
1-1-3 Shimaya Konohanaku
Osaka-shi Osaka (JP)

(74) Representative: Grünecker, Kinkeldey, Stockmair & Schwanhäusser Anwaltssozietät
Maximilianstrasse 58
80538 München (DE)

# (54) Semiconductor light emitting device

(57) A ZnSe based light emitting device enabling longer lifetime is provided. The light emitting device is formed on a compound semiconductor, includes an active layer (4) positioned between an n-type ZnMgSSe cladding layer (3) and a p-type ZnMgSSe cladding layer (5), and has a barrier layer (11) having a band gap larger than that of the p-type ZnMgSSe cladding layer, provided between the active layer (4) and the p-type ZnMgSSe cladding layer (5).

FIG.1

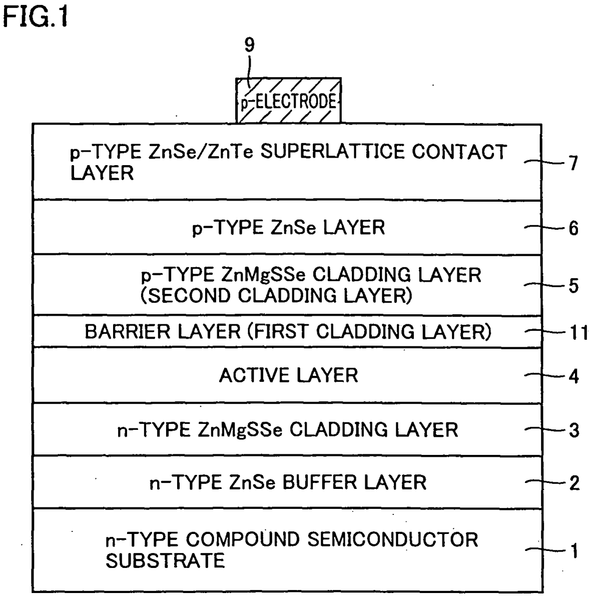




Printed by Jouve, 75001 PARIS (FR)

**Description**

BACKGROUND OF THE INVENTION

Field of the Invention

The present invention relates to a semiconductor light emitting device.

Description of Related Art

A ZnSe crystal is a direct transition type semiconductor having forbidden bandwidth (band gap energy) of 2.7 eV at a room temperature, expected to have a wide range of applications for a light emitting device in the wavelength range of blue to green. Particularly after 1990 when it was found that a p-type ZnSe film could be formed by doping plasma-excited nitrogen, ZnSe type light emitting devices have attracting attention.

The inventors have devised a white LED (Light Emitting Diode) having a novel structure using a ZnSe substrate for practical use. The white LED utilizes SA (Self-Activated) light emission of an n-type ZnSe substrate. Specific structure of a light emitting device is as shown in Fig. 19, in which on an n-type ZnSe substrate 101, a buffer layer (N-type ZnSe) 102, an n-type cladding layer (N-type ZnMgSe) 103, an active layer (ZnCdSe/ZnSe multiquantum well) 104, a p-type cladding layer (p-type ZnMgSSe) 105 and a contact layer (ZnSe/ZnTe superlattice layer on p-type ZnSe) 106 are stacked in this order, with a p-electrode (not shown) formed on top of the stacked structure and an n-electrode (not shown) formed on a back surface of ZnSe substrate 101.

When a current is introduced by conducting these electrodes to cause emission of blue light (having the wavelength of around 485 nm) at active layer 104, part of the blue light is directly emitted to the outside of the device, and another part enters the substrate side. The blue light entering ZnSe substrate 101 excites an SA center in the ZnSe substrate, and as a result, induces SA light emission. The SA light emission has a peak at around 590 nm, and when mixed with a blue light having the wavelength of 485 nm with an appropriate ratio, a light that is perceived as white by human eyes can be obtained. The ZnSe based white LED has a driving voltage as low as about 2.7 V and relatively high light emission efficiency, and therefore, applications thereof are hoped for.

The ZnSe based light emitting device, however, has a problem of short lifetime. The lifetime of the ZnSe based light emitting device will be described in the following. In a semiconductor light emitting device, an active layer that emits light is positioned between an n-type semiconductor cladding layer and a p-type semiconductor cladding layer, and has a band gap that is smaller than the band gap of these two cladding layers. At the time of light emission, electrons and holes are introduced from the n-type cladding layer and from the p-type cladding layer to the active layer to create electron-hole recombination and to cause light emission by the recombination. The electrons introduced from the n-type cladding layer to the active layer mainly follow the courses below.

(1) Re-combined with holes and emit light.
(2) Leak (overflow) to the p-type cladding layer, resulting in recombination without light emission in the p-type cladding layer.

When the ratio of electrons that follow the course (2) is large, light emission efficiency lowers, and therefore, optical output from a light emitting device (LD: Laser Diode, LED) becomes smaller. In order to solve the problem related to the course (2) above, an energy barrier (hetero barrier; $\Delta Ec$) against electrons of the p-type cladding layer on the side of the active layer may be increased, so that leakage of electrons is reduced. Specifically, $\Delta Ec$ is a difference in quasi-Fermi level between energy at the bottom of a conductive band of the p-type cladding layer and electrons in the active layer. Though it is difficult to accurately calculate $\Delta Ec$, there are the following three methods of increasing the barrier.

(1) Increasing the difference $\Delta Eg$ between the band gap of the p-type cladding layer and the band gap of the active layer.
(2) Lowering the Fermi level of the p-type cladding layer by increasing carrier density of the p-type cladding layer.
(3) Lowering current density to be introduced to the active layer.

Among these, method (3) is meaningless in realizing a light emitting device having high intensity. As method (1) above, by way of example, use of a ZnMgSSe layer as the cladding layer in a ZnSe based light emitting device has been proposed (see, for example, Japanese Patent Laying-Open No. 5-75217). When ZnMgSSe is used as mentioned above, it becomes possible to increase the band gap to as large as about 4.4 eV, under the condition that the lattice constant thereof is adapted to match that of ZnSe.

In a ZnSe based device, however, it is impossible to apply methods (1) and (2) independent of each other, and when method (1) only is pursued, the problem cannot be solved. Methods (1) and (2) are related with each other because of doping characteristics of the ZnSe based compound semiconductor. The doping characteristics of the ZnSe based semiconductor will be described in the following.

It has been known that, when a p-type impurity is introduced, in an equilibrium state, to a II-VI group compound semiconductor to which the ZnSe based compound semiconductor belongs, sufficient p-type conductivity cannot stably be attained, and that p-type conductivity is attained only when nitrogen is introduced during low-temperature growth by MBE (Molecular Beam Epitaxy) method. This doping, however, becomes more difficult as the band gap becomes wider, and the highest possible p-type carrier density becomes smaller as the band gap becomes wider. Fig. 20 shows the result of this phenomenon.

Fig. 20 shows a relation between the band gap of ZnMgSSe of which composition ratio is adjusted to have matching lattice constant with ZnSe, and effective p-type carrier density (Na-Nd). Here, Na represents an acceptor density, while Nd represents a donor density. It can be seen that when the band gap of ZnMgSSe increases, (Na-Nd) decreases. Possible cause is that even when only nitrogen (N) as the p-type impurity is introduced as dopant, donor-related defects (details unknown) tend to form more likely when the band gap is increased. Specifically, in the ZnSe based compound semiconductor, when the band gap is increased, density of donor-related defects increases, that is, Nd increases. Therefore, p-type carrier density does not substantially increase but rather the p-type carrier density decreases because of the formation of donor-related defects.

From the phenomenon above, it is understood that there is an optimal band gap value of the p-type cladding layer for maximizing hetero barrier $\Delta Ec$. Specifically, there is such a relation between the two as schematically shown in Fig. 21. In Fig. 21, the optimal band gap value mentioned above is represented as a critical value. It is expected that the band gap of the p-type cladding layer is set to the critical value by a solution attained by putting together the methods (1) and (2), so that the maximum hetero barrier $\Delta Ec$ is realized and leakage of electrons are sufficiently suppressed.

Though it depends on doping technique, the optimal band gap value mentioned above is around 2.9 eV to around 3.0 eV. There will be no problem if the hetero barrier $\Delta Ec$ obtained with this optimal band gap is sufficiently large and as a result the leakage of electrons decreases sufficiently. Actually, however, it has been found that even when the optimal band gap in the p-type cladding layer is realized, the hetero barrier $\Delta Ec$ is not large enough and that considerable amount of electrons leak from the active layer to the p-type cladding layer.

A harder problem of the light emitting device formed of ZnSe based compound semiconductor is that leakage of electrons to the p-type cladding layer not only decreases light emitting efficiency but also reduces the lifetime of the light emitting device. This phenomenon will be described in the following.

As described earlier, in the II-VI group compound semiconductor, to which ZnSe belongs, stability of a p-type dopant is low. Therefore, the p-type carrier density cannot be increased. In addition, donor-related defects are formed by the energy emitted when the electrons that have been leaked to the p-type cladding layer are recombined with the holes in the p-type cladding layer, decreasing the p-type carrier density. When the p-type carrier density decreases, hetero barrier $\Delta Ec$ reduces, and therefore the function as a barrier against electron leakage is undermined. This results in a vicious circle of (leakage of electrons to p-type cladding layer) $\rightarrow$ (decrease of p-type carrier density in p-type cladding layer) $\rightarrow$ (decrease of hetero barrier $\Delta Ec$) $\rightarrow$ ..., catastrophically lowering light emission efficiency. Specifically, rapid degradation starts after a short period of operation. Because of the phenomenon described above, it has been considered that the ZnSe based light emitting device inherently has a short lifetime and that it is difficult to make the lifetime longer.

## SUMMARY OF THE INVENTION

An object of the present invention is to provide a ZnSe based light emitting device that has longer lifetime.

The present invention provides a ZnSe based light emitting device of a II-VI group compound semiconductor formed on a compound semiconductor substrate and having an active layer between an n-type cladding layer and a p-type cladding layer, including a semiconductor barrier layer having a band gap larger than a band gap of the p-type cladding layer, provided between the active layer and the p-type cladding layer.

Because of this structure, electrons introduced to the active layer are prevented from moving to the p-type cladding layer because of the barrier potential attained by the band gap of the barrier layer larger than that of the p-type cladding layer.

Consequently, the lifetime of the ZnSe based light emitting device can significantly be improved.

The gist of the present structure resides in that, of the two roles played by a common p-type cladding layer, that is, "supplying holes to the active layer" and "suppressing electron leakage by forming hetero barrier," the role of "suppressing electron leakage by forming hetero barrier" is assumed by the barrier layer. The p-type cladding layer is responsible only for "supplying holes to the active layer." A large band gap or large carrier density is not much required of the p-type cladding layer that simply bears the burden of "supplying holes to the active layer." As to the suppression of electron leakage by the barrier layer, if the band gap of the barrier layer is sufficiently large, it is possible to ensure sufficiently large hetero barrier ΔEc with respect to the quasi-Fermi level of the active layer, even in the absence of increase of the hetero barrier ΔEc attained by increasing the carrier density.

A particular advantage of the above described structure is that efficiency of electron confinement is not much dependent on the carrier density of the cladding layer. Therefore, even when the carrier (hole) density of the p-type cladding layer decreases because of the leakage current coming over the barrier layer, the efficiency of electron confinement is almost free of any influence and maintained as it is. As a result, the accelerated increase of leakage amount caused by the vicious circle suffered by the conventional structure is not induced, and the catastrophic deterioration of the device can be prevented.

Here, the effect of confinement by the barrier layer will be described. Basically, when the difference between the quasi-Fermi level of electrons in the active layer and the energy level at the bottom of the conductive band in the barrier layer is large, the efficiency of confinement improves. In order to increase the energy difference, that is, hetero barrier ΔEc, the most basic approach is to increase the band gap of the barrier layer. When ZnMgSSe is used as the barrier layer, the band gap of the barrier layer may be increased by increasing the composition ratio of Mg and S. Here, the carrier density of the barrier layer is not important, and the conventional limitation on the carrier density of the p-type cladding layer is eliminated.

Though intentional doping of the barrier layer with a p-type impurity is unnecessary, doping to some extent does not cause any problem. The material of the barrier layer is not limited to ZnMgSSe. Any material other than ZnMgSSe may be used provided that it has a larger band gap than the cladding layer and, as a result of the larger band gap, the energy level of the bottom of the conductive band is elevated (or electron affinity lowers). It is necessary, however, that the lattice constant of the material approximately matches that of the semiconductor substrate, for example, a ZnSe substrate. An example of such material is ZnMgBeSe. Compared with ZnMgSSe, ZnMgBeSe is known to attain smaller electron affinity, and therefore, if the band gap is the same, ZnMgBeSe is more preferable as it attains higher efficiency of electron confinement.

When the barrier layer is formed of ZnMgSSe or ZnMgBeSe, the larger the band gap thereof, the higher the efficiency of electron confinement. When the band gap is made too large, however, crystal characteristic of the film serving as the barrier layer tends to deteriorate, and therefore, excessive increase should be avoided. When the band gap of the barrier layer is made too large as compared with the band gap of the p-type cladding layer, it will be a barrier against introduction of holes from the p-type cladding layer to the active layer, undesirably decreasing the light emission efficiency.

Here, in a light emitting device formed of a III-V group compound semiconductor, the aforementioned formation of a barrier against holes introduced from the p-type cladding layer to the active layer does not pose a serious problem. In the ZnSe based compound semiconductor, however, different from the compound semiconductor of the III-V group, when there is the above described barrier between the barrier layer and the p-type cladding layer, p-type doping becomes instable, and deterioration is likely. Therefore, the barrier against introduction of holes from the p-type cladding layer to the active layer should desirably be small. When ZnMgSSe and ZnMgBeSe are compared with respect to the barrier, when the band gap is the same, ZnMgBeSe results in a smaller barrier against holes or the above described barrier is not formed, and therefore, ZnMgBeSe is preferred.

As can be seen from the description above, the band gap of the barrier layer has an optimal value. The optimal value depends on the material of the barrier layer, the band gap of the p-type cladding layer, stability of p-type doping of the p-type cladding layer and so on, and therefore it cannot be determined in a simple manner. It is noted, however, that the optimal value of the barrier layer band gap exists in a range 0.025 eV to 0.5 eV larger than the band gap of the p-type cladding layer. Even when the value is off from the optimal value to some extent, the above described role of the barrier layer can be expected provided that the band gap is in the range of 0.025 eV to 0.5 eV larger than the band gap of the p-type cladding layer.

According to another aspect, the present invention provides a semiconductor light emitting device formed on a compound semiconductor substrate, having an active layer sandwiched between two cladding layers, wherein one of the two cladding layers is a p-type semiconductor to which a p-type impurity is introduced, and the other cladding layer is an undoped semiconductor.

By the above described structure, Fermi level of electrons in the active layer can be decreased. Therefore, it becomes possible to reduce the margin of lowering of a conductive band portion (hereinafter referred to as a conductive band lowering boundary) of the p-type cladding layer that is adjacent to the active layer and has been bent and lowered by the electric field. Accordingly, the barrier against electrons that leak from the active layer to the p-type cladding layer is not much lowered at the conductive band lowering boundary. As a result, leakage of electrons from the active layer to the p-type cladding layer can be suppressed, and the lifetime of the light emitting device can be made longer.

An undoped semiconductor refers to a semiconductor not doped with any dopant, that is, neither with p-type dopant nor with n-type dopant. The concentration of residual dopant in the undoped semiconductor must generally be smaller than the dopant concentration attained by the doping process, no matter whether it is n-type or p-type. By way of example, when doping is performed to prepare a p-type or n-type semiconductor, it is a common practice to set the p-type or n-type impurity concentration to at least $10^{16}/cm^3$. Therefore, the residual impurity concentration of the undoped semiconductor should be lower than $10^{16}/cm^3$, no matter whether the impurity is p-type or n-type.

Generally, a semiconductor contains both n-type and p-type impurities, and the conductivity type of the semiconductor is defined by the impurity that is dominant. Impurity concentration of the semiconductor is determined by the amount of impurity remaining after the impurities of both types are offset with each other. The aforementioned impurity concentration of $10^{16}/cm^3$ is the concentration determined by the amount of remaining impurity after the impurity concentrations of both types are offset with each other, and it represents the impurity concentration of the conductivity type of the semiconductor.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 shows a ZnSe based light emitting device in accordance with a first embodiment of the present invention.
Fig. 2 shows a stacked structure in which ZnBeMgSe is used for a barrier layer.
Fig. 3 shows a stacked structure in which ZnMgSSe is used for a barrier layer.
Fig. 4 shows a band structure in which ZnBeMgSe is used for a barrier layer.
Fig. 5 shows a band structure in which ZnMgSSe is used for a barrier layer.
Fig. 6 shows a result of lifetime test of a light emitting device under accelerating condition.
Fig. 7 shows an LED in accordance with a second embodiment of the present invention.
Fig. 8 shows an energy band of the LED shown in Fig. 7.
Fig. 9 shows another LED in accordance with the second embodiment of the present invention.
Fig. 10 shows an LED in accordance with a third embodiment of the present invention.
Fig. 11 shows an energy band of layers including two cladding layers of the LED shown in Fig. 10 (barrier layer: ZnMgBeSe).
Fig. 12 shows an energy band of layers including two cladding layers when the barrier layer of the LED shown in Fig. 11 is formed of ZnMgSSe.
Fig. 13 shows time-change in relative luminance of an LED in accordance with the present invention and an LED as a comparative example.
Fig. 14 shows a light emitting device in accordance with a fourth embodiment of the present invention.
Fig. 15 represents an energy band in a state where a voltage is applied to the light emitting device of Fig. 14.
Fig. 16 represents an energy band in a state where a voltage is applied to a conventional light emitting device as a comparative example.
Fig. 17 shows a light emitting device in accordance with a fifth embodiment of the present invention.
Fig. 18 represents an energy band in a state where a voltage is applied to the light emitting device of Fig. 17.
Fig. 19 shows a conventional light emitting device.
Fig. 20 shows a relation between (Na-Nd) and band gap Eg in ZnMgSSe.
Fig. 21 shows a relation between the magnitude of band gap of the p-type cladding layer and band offset $\Delta Ec$ on the side of the conductive band.

DESCRIPTION OF THE PREFERRED EMBODIMENTS

In the following, the light emitting devices in accordance with the embodiments of the present invention will be described with reference to the figures.

(First Embodiment)

Fig. 1 shows a ZnSe based light emitting device in accordance with an embodiment of the present invention. On an n-type compound semiconductor substrate 1, an n-type ZnSe based buffer layer (hereinafter referred to as an n-type buffer layer) 2 is positioned, and an n-type ZnMgSSe cladding layer (hereinafter referred to as an n-type cladding layer) 3 is formed thereon. As the n-type compound semiconductor substrate 1, an n-type ZnSe single crystal substrate or an n-type GaAs single crystal substrate may be used. The n-type GaAs single crystal substrate is advantageous in that it is easier to form an ZnSe based epitaxial layer thereon and in addition, it is inexpensive.

On the n-type cladding layer 3, an active layer 4 is positioned, in which a quantum well layer and a barrier layer thereof are stacked. A barrier layer (first cladding layer ) 11 is further positioned thereon, and on the barrier layer, a p-type ZnMgSSe cladding layer (hereinafter referred to as a p-type cladding layer or a second cladding layer) 5 is formed.

As the barrier layer, an i-type $Zn_{1-x-y}Mg_xBe_ySe$ ($0.01 \leq y \leq 0.1$) may be used, as shown in Fig. 2. Alternatively, as the barrier layer, an i-type $Zn_{1-x}Mg_xS_{1-y}Se_y$ may be used. It is noted that the barrier layer is not limited to an intrinsic compound semiconductor and it may contain a p-type impurity.

On the p-type cladding layer, a p-type ZnSe buffer layer 6 is positioned, a p-type ZnSe/ZnTe superlattice contact layer 7 is formed thereon, and a p-electrode 9 is further provided thereon. Though an n-electrode is formed on n-type compound semiconductor substrate 1, it is not shown. A voltage is applied between the n- and p-electrodes to introduce current to the active layer, so as to cause light emission.

Figs. 4 and 5 show a band structure at the n-type cladding layer 3/active layer 4/barrier layer 11/p-type cladding layer 5. Between active layer 4 and p-type cladding layer (second cladding layer) 5, barrier layer (first cladding layer) 11 is provided, so as to form a barrier potential against leakage of electrons in the active layer to the p-type cladding layer. Specifically, electrons are confined in the active layer. In Fig. 4, there is no discontinuity between the barrier layer and the valence band of the p-type cladding layer, and the connection is continuous. Such a connection is possible only when ZnMgBeSe is used as the barrier layer, and when ZnMgSSe is used as the barrier layer, a barrier is formed also on the side of the valence band at the interface between the barrier layer and the p-type cladding layer, as shown in Fig. 5. Even when ZnMgBeSe is used as the barrier layer, a barrier is formed on the side of the valence band as shown in Fig. 5, if the band gap thereof is made too large.

Next, a method of manufacturing the light emitting device in accordance with the present embodiment will be described. First, by the MBE method, the stacked structure shown in Fig. 1 was formed on a conductive ZnSe substrate having the plane orientation of (100). As to the composition ratio of n-type and p-type cladding layers, a composition that realizes the band gap of 2.9 eV at a room temperature and attains substantial lattice matching with the ZnSe substrate was adopted. As the barrier layer, a ZnMgBeSe layer having the band gap of 3.1 eV (room temperature) and thickness of 20 nm and also substantially lattice-matched with the ZnSe substrate was used. Here, n-type ZnMgSSe layer 3, barrier layer 1 (first cladding layer) 11 and p-type ZnMgSSe layer (second cladding layer) 5 require Mg of different compositions, respectively, and therefore, different Mg fluxes are required during growth. Therefore, a plurality ofK cells may be used as an Mg source. In the present embodiment, however, a single K sell is used, and the temperature of the K cell for Mg was changed during the growth. Therefore, before the growth of barrier layer 11 and p-type ZnMgSSe layer 5, the temperature of the K cell for Mg was changed, and the growth was interrupted until the temperature became stable.

As to the measurement of the band gap of each layer at the room temperature, utilizing light emission wavelength of PL (Photo-Luminescent) light emission (light emission caused by recombination of excitons) near the band end at 4.2 K, the band gap at a room temperature was calculated using the following equation (I).

$$Eg(eV) = \{1240/\lambda_{4.2PL}(nm)\} - 0.1 \qquad (I)$$

In the equation (I), 0.1 eV is subtracted, which corresponds to the decrease in the band gap caused by the temperature increase from 4.2K to the room temperature. Though the equation above is not necessarily accurate but involves a systematic error, the equation is simple and therefore, it is adopted as an approximate expression.

Matching of lattice constant can be evaluated based on a deviation in diffraction angle of (400) diffraction by X-ray. After the stacked structure of layers 2~8 is formed by the MBE method, when the diffraction line is measured, a strong diffraction from the ZnSe substrate and a relatively weak diffraction from the cladding layer can be observed. From the difference in the diffraction angle between these two, degree of lattice matching of the cladding layer can be evaluated. It is noted, however, that the diffraction peak of the barrier layer cannot be observed. Therefore, in a growth for setting condition made beforehand, a relatively thick ZnMgBeSe or a ZnMgSSe film is formed on the ZnSe substrate, and lattice matching is evaluated by measuring the X-ray diffraction angle. Similar measurement is taken for the band gap.

Though Cl is used as the n-type impurity and N is used as the p-type impurity, selection of these is not an essential factor of the present invention, and the impurities used are not limited to those mentioned above.

Though ZnMgSSe is used for the n-type and p-type cladding layers and the band gaps of these are of the same value, such selection is not an essential factor of the present invention, either. Different ZnSe based compound semiconductors may be used as the n-type and p-type cladding layers, and the band gaps of these may be different from each other.

[Example]

The LED of the present invention having the stacked structure as shown in Fig. 1 was fabricated and the lifetime thereof was measured. As a comparative example, an LED having a conventional structure not provided with barrier layer (first cladding layer) 11 of the stacked structure of Fig. 1 was fabricated. Here, other layers of the stacked structure were made to have the same thickness and same band gap as those of the present embodiment (example of the present invention).

After respective layers of the stacked structure shown in Fig. 1 were formed, an n-electrode of Ti/Au was formed on the back side of ZnSe substrate 1. Further, on the p-type ZnSe/ZnTe superlattice contact layer 8, a semitransparent Au electrode having the thickness of about 200 Å was formed. Thereafter, the structure was scribe-broken to 400 μm × 400 μm, bonded to a stem and an LED for lifetime evaluation was prepared.

Before formation of electrodes, (400) diffraction of X-ray ($K_{\alpha 1}$ line of Cu) was measured, and it was confirmed that the diffraction peaks of the n-type and p-type cladding layers have the deviation of at most 400 seconds from the diffraction peak of the ZnSe substrate. As to ZnMgBeSe, in the growth for setting condition performed immediately before LED growth, (400) diffraction of X-ray ($K_{\alpha 1}$ line of Cu) was measured, and it was also confirmed that the deviation was at most 400 seconds as compared with the diffraction peak of the ZnSe substrate.

Lifetimes of the LEDs as an example of the present invention and as a comparative example fabricated in accordance with the process steps described above were measured. As a method of measurement, a constant current of 15 mA was caused to flow at 70 °C and change in luminance was measured. Fig. 6 shows the result of measurement. It can be seen from Fig. 6 that the luminance of the comparative example having the conventional structure was decreased to about 70 % of the initial luminance after about 20 hours. In contrast, in the example of the present invention, it took more than 400 hours until the luminance was decreased to about 70 % of the initial luminance. Thus, it can be understood that degradation of luminance with time can significantly be suppressed in the LED of the present invention.

The degradation is suppressed as described above, because degradation of the p-type cladding layer is prevented as leakage of electrons to the side of the p-type cladding layer is suppressed, and because the efficiency of confinement is maintained even after the p-type cladding layer is deteriorated. Practical application of the conventional ZnSe based light emitting device has been hindered as the device is prone to degradation and has short lifetime. Because of the structure described above, the light emitting device of the present invention overcomes these defects.

(Second Embodiment)

Fig. 7 shows an LED as a semiconductor light emitting device in accordance with the second embodiment of the present invention. In fabricating LED 10 as an example of the present invention, an n-type ZnSe substrate 1 having the plane orientation of (100) was used. On n-type ZnSe substrate 1, an n-type ZnSe film 2 as a buffer layer/an n-type ZnMgSSe layer 3 as an n-type cladding layer/(ZnCd/ZnSe multiquantum well) 4 as an active layer/a ZnMgBeSe layer 11 as a barrier layer/a ZnSe layer 12 as a trap layer/ a p-type ZnMgSSe layer 5 as a p-type cladding layer/(ZnTe/ZnSe superlattice/p-type ZnSe layer) 6,7 as a contact layer, are epitaxially formed in this order, from the lower side.

[Example]

The LED shown in Fig. 7 was fabricated and the lifetime thereof was measured. The aforementioned epitaxial growth was performed by MBE (Molecular Beam Epitaxy) method. As the n-type dopant, chlorine Cl was used, and as the p-type dopant, nitrogen N was used. N-type cladding layer 3 and p-type cladding layer 5 were adapted to have the band gap energy of 2.9 eV, and barrier layer 11 was adapted to have the band gap energy of 3.1 eV. Further, Cd composition was adjusted such that light emission wavelength of active layer 4 attains to 485 nm.

The n-type cladding layer 3 and the p-type cladding layer both had the thickness of about 0.5 μm, barrier layer 11 had the thickness of about 0.02 μm, and trap layer 12 had the thickness of about 0.05 μm. As to the impurity concentration, the p-type impurity concentration of the p-type cladding layer was $3 \times 10^{16}/cm^3$, and the p-type impurity concentration of the trap layer was $3 \times 10^{17}/cm^3$. On the LED, an n-electrode and a p-electrode, not shown, are provided. On a back surface 1a of n-type ZnSe substrate 1, an n-electrode formed of Ti/Au film is provided, and on an upper surface 7a of contact layer 6,7, a p-electrode formed of a semitransparent Au film having the thickness of about 10 nm is provided. A unit area of 400 μm × 400 μm of the LED described above was formed on an n-type ZnSe substrate and thereafter scribe-broken to the unit area of 400 μm × 400 μm to obtain a piece. The thus provided piece as a chip was bonded on a stem to fabricate an LED (example of the present invention) for evaluating the lifetime thereof.

Fig. 8 shows an energy band of the portion including n-type cladding layer 3/active layer 4/barrier layer 11/trap layer 12/p-type cladding layer 5 of the LED shown in Fig. 7. Because of such an energy band structure, electrons going from the active layer to the p-type cladding layer are first prevented by the potential of barrier layer 11. Most of the electrons that leaked over the barrier layer 11, however, are trapped by the defects in trap layer 12, recombined with the holes and disappear. Therefore, trap layer 12 serves as a sink. Consequently, number of electrons that can reach the p-type cladding layer is significantly reduced. The band gap of trap layer 12 have only to be larger than that of the p-type cladding layer, and it is unnecessary to set the band gap to be the same as a larger one of the layers in the active layer that generally includes a plurality of layers.

For comparison, an LED as a comparative example was fabricated, which had the same stacked structure as the LED described above except that the barrier layer and the trap layer were not provided. Specifically, the LED having the stacked structure shown in Fig. 19 was used as the comparative example.

The LEDs as the example of the present invention and as the comparative example were tested under the following conditions. A constant current of 15 mA was caused to flow through the LEDs at 70 °C and decrease in luminance over time was measured. The test result was as follows. In the LED as the comparative example, it took 200 to more than 500 hours until the luminance was decreased to 70 % of the initial luminance, and the average time was about 350 hours. In contrast, in the LED of the present invention, it took 350 to more than 700 hours until the luminance was decreased to 70 % of the initial luminance, and the average was about 500 hours.

From the test result above, it was found that the LED in accordance with the embodiment of the present invention enables about 40 % longer lifetime as compared with the prior art.

In an LED shown in Fig. 9 as a modification of the second embodiment of the present invention, a multi-stacked structure in which two such portions including the barrier layer and the trap layer are arranged between the active layer and the p-type cladding layer. By such multi-stacked structure, leakage of electrons to the p-type cladding layer can more surely be prevented, and the lifetime of the semiconductor light emitting device can further be made longer.

(Third Embodiment)

Fig. 10 shows an LED (Light Emitting Diode) as a semiconductor light emitting device in accordance with a third embodiment of the present invention. For fabricating the LED as an example of the present invention, an n-type ZnSe substrate 1 having the plane orientation of (100) was used. On the n-type ZnSe substrate 1, an n-type ZnSe film 2 as a buffer layer/an n-type ZnMgSSe layer 3 as an n-type cladding layer/(ZnCdSe/ZnSe multiquantum well) 4 as an active layer/an ZnMgBeSe layer 11 as barrier layer/a ZnCdS layer 5 as a p-type cladding layer/(ZnTe/ZnSe superlattice layer/p-type ZnSe layer) 6, 7 as a contact layer are epitaxially formed in this order from the lower side.

Fig. 11 shows an energy band when the barrier layer was formed of ZnMgBeSe as described above. It is possible by a II-VI group compound semiconductor including Be, particularly, $Zn_{1-x-y}Mg_xBe_ySe$ to elevate the bottom of the conductive band while not much changing the top of the valence band, as shown in Fig. 11. Therefore, it becomes possible to form a barrier against electrons that are about to leak from the active layer to the p-type cladding layer while presenting no barrier against the holes going from the side of the p-type cladding layer to the active layer, and therefore, contribution to the increase of luminance by the introduction of holes is not hindered.

The barrier layer may be formed of ZnMgSSe, and Fig. 12 shows an energy band where the barrier layer is formed of ZnMgSSe. As shown in Fig. 12, ZnMgSSe elevates the bottom of the conductive band and lowers the top of the valence band. Therefore, as compared with an example in which the barrier layer is formed of ZnMgBeSe layer, introduction of holes from the p-type cladding layer to the active layer is prevented, and therefore, light emission efficiency may be lower than when the barrier layer is formed of ZnMgBeSe.

[Example]

The LED as an example of the present invention shown in Fig. 11 was fabricated and the lifetime thereof was measured. The epitaxial film formation was performed by the MBE method. As the n-type dopant, chlorine Cl was used, and as the p-type dopant, nitrogen N was used. N-type cladding layer 3 and p-type cladding layer 5 were adapted to have the band gap energy of 2.9 eV, and barrier layer 11 was adapted to have the band gap energy of 3.1 eV. Further, Cd composition was adjusted such that light emission wavelength of active layer 4 attains to 485 nm.

The n-type cladding layer 3 and the p-type cladding layer both had the thickness of about 0.5 μm, and barrier layer 11 had the thickness of about 0.02 μm. As to the impurity concentration, the p-type impurity concentration of the p-type cladding layer was $3 \times 10^{16}/cm^3$. On the LED, an n-electrode and a p-electrode, not shown, are provided. On a back surface 1a of n-type ZnSe substrate 1, an n-electrode formed of Ti/Au film is provided, and on an upper surface 7a of contact layer 6,7, a p-electrode formed of a semitransparent Au film having the thickness of about 10 nm is provided. A unit area of 400 μm × 400 μm of the LED described above was formed on an n-type ZnSe substrate and thereafter scribe-broken to the unit area of 400 μm × 400 μm to obtain a piece. The thus provided piece as a chip was bonded on a stem to fabricate an LED (example of the present invention) for evaluating the lifetime thereof.

For comparison, an LED as a comparative example having the stacked structure shown in Fig. 19 was fabricated.

The LEDs as the example of the present invention and as the comparative example were tested under the following conditions. A constant current of 15 mA was caused to flow through the LEDs at 70 °C and decrease in luminance over time was measured. The test result was as shown in Fig. 13. Specifically, in the LED as the comparative example, it took 200 to more than 500 hours until the luminance was decreased to 70 % of the initial luminance, and the average time was about 350 hours. In contrast, in the LED of the present invention, it took 350 to more than 700 hours until the luminance was decreased to 70 % of the initial luminance, and the average was about 500 hours.
From the test result above, it was found that the LED in accordance with the embodiment of the present invention enables about 40 % longer lifetime as compared with the prior art.

(Fourth Embodiment)

Referring to Fig. 14, in a semiconductor light emitting device 10 in accordance with the present embodiment, on an n-type ZnSe substrate 1, an n-type ZnSe layer as a buffer layer 2, an undoped ZnMgSSe layer as an undoped cladding layer 3, an active layer 4 having a multiquantum well structure of ZnCdSe/ZnSe, a p-type ZnMgSSe layer as a p-type cladding layer 5, and a contact layer 6, 7 having a multiquantum well structure of ZnTe/ZnSe and a p-type ZnSe layer are stacked in this order from the lower side. Two cladding layers 3 and 5 sandwich active layer 4. Here, cladding layer 3 positioned below active layer 4, that is, on the side of ZnSe substrate 1 is the undoped ZnMgSSe layer, while cladding layer 5 positioned above the active layer, that is, positioned farther away from the active layer when viewed from the ZnSe substrate is the p-type ZnMgSSe layer. In the following description, the undoped cladding layer positioned below the active layer may be referred to as an n-electrode side cladding layer, and the p-type cladding layer positioned above the active layer may be referred to as a p-electrode side cladding layer. Further, cladding layers of the conventional light emitting device shown in Fig. 19 may be referred to in the similar manner.
The impurity concentration of undoped ZnMgSSe layer 3 is controlled to a level lower than a typical level attained by doping an impurity, regardless of p-type or n-type. The impurity concentration is lower than $10^{16}/cm^3$.
Next, the function of semiconductor light emitting device 10 shown in Fig. 14 will be described. Fig. 15 shows the band where a current is introduced by applying a voltage to electrodes, not shown, of the light emitting device having the structure shown in Fig. 14. Fig. 16 shows the band where a current is introduced by applying a voltage to electrodes of a light emitting device having the stacked structure shown in Fig. 19 in which an n-type cladding layer doped with an n-type impurity is provided in place of undoped cladding layer 3.
In Figs. 15 and 16, reference character V represents a difference between quasi Fermi level $\phi n$ of electrons and quasi Fermi level $\phi p$ of holes in the active layer. The value V determines the recombination probability of electrons and holes in the active layer, and it is determined substantially uniquely by the amount of current introduced to the device. Precisely, the value V cannot be determined solely by the amount of introduced current as there is leakage current. In the present description, however, there arises no problem even when it is assumed that the value is determined by the amount of current introduced to the device. When there is no voltage lowering caused by electric resistance at the electrodes or in each layer, the value V will be the same as the voltage applied between the electrodes. The value Ef(p-cladding layer) represents Fermi level of holes measured from the top of the valence band on the p-type cladding layer, which becomes smaller as the p-type carrier density increases.
The band of the conventional light emitting device as a comparative example will be described first. As can be seen from Fig. 16, $\Delta Ec$ can be given by the following equation (1).

$$\Delta Ec = Eg(\text{p-cladding layer}) - V - Ef(\text{p-cladding layer}) \quad (1)$$

As described above, possible approach to increase $\Delta Ec$ is to increase the band gap energy (Eg(p-cladding layer)) of the p-type cladding layer, to decrease the value V by decreasing the introduced current, or to increase p-type carrier density to reduce Ef(p-cladding layer). It is noted here that the absolute position of the quasi Fermi level ($\phi n$, $\phi p$) in the active layer does not have any influence on $\Delta Ec$. Even if the position of $\phi n$ were lowered while maintaining the value V constant, $\Delta Ec$ would be unchanged as the bottom position of the conductive band of the p-type cladding layer would also be lowered, drawn by the lowering of $\phi p$, as schematically shown in Fig. 15. Accordingly, the absolute position of the quasi Fermi level ($\phi n$, $\phi p$) in the active layer has not been seriously taken into consideration.
The situation is different, however, when a material has instable p-type doping and is prone to deterioration, such as in the case of ZnSe. Specifically, though confinement of carriers in the active layer should be discussed in relation to $\Delta Ec$, not only $\Delta Ec$ but also $\Delta Ec'$ (see Figs. 15 and 16) would be important when degradation of the p-type cladding layer is taken into consideration. Specifically, at that portion of the p-type cladding layer which is adjacent to the active layer and the band is bend by the electric field (region A of Figs. 15 and 16), barrier against electrons would be lower if $\Delta Ec'$ is small, even when $\Delta Ec$ is the same. This means that leakage becomes more likely, and eventually, degradation of the p-type cladding layer becomes more likely. Here, it should be noted that though the absolute position of the quasi Fermi level (ϕn, ϕp) in the active layer does not have any influence on ΔEc as described above, the quasi Fermi level does have an influence on ΔEc' as described above.

From the foregoing, from the viewpoint of suppressing leakage of electrons, the larger value ΔEc' is preferred. In order to increase ΔEc', possible approach is to lower the Fermi level of electrons ϕn to reduce bending of the band of the p-type cladding layer, as can be understood from a comparison between Figs. 15 and 16.

The next problem is how to decrease ϕn. It is a natural prerequisite that the value V mentioned above is kept constant. It is generally difficult to increase the p-type carrier density in a compound semiconductor used as a material of the cladding layer in a common light emitting device. Therefore, when an n-type cladding layer and a p-type cladding layer are compared, the carrier density of the n-type cladding layer tends to be higher than the carrier density of the p-type cladding layer. The Fermi levels ϕn and ϕp of the electrons and holes in the active layer are determined by the amounts of electrons and holes introduced from the cladding layer, and therefore, if the carrier density of the n-electrode side cladding layer is high, introduction of electrons is facilitated, and as a result, the level ϕn becomes higher.

In view of the foregoing, an approach has been found in which the p-type cladding layer is doped with a p-type impurity in the conventional manner so that it comes to have p-type conductivity, while the n-electrode side cladding layer is undoped. By this approach, introduction of electrons to the active layer is hindered, that is, electrons are less accumulated, and the Fermi level ϕn in the active layer lowers. There was a concern that if the n-electrode side cladding layer were undoped and made to have high electric resistance, current would not flow through the light emitting device. It was found by actual experimental prototype that electrons diffused from the n-type buffer layer 2 to n-electrode side cladding layer 3 and the current flew.

Another concern was that as the barrier against holes of the n-electrode side cladding layer 3 became lower, leakage of holes to the n-electrode side cladding layer would be more likely. In the compound semiconductor material used for the light emitting device, however, mobility of holes is far smaller than that of electrons, and therefore, leakage of holes is inherently small. Thus, that concern proved unfounded. Even if such a problem were not negligible, it could be readily solved by simply increasing the band gap of n-electrode side cladding layer 3.

It is difficult to confirm by direct measurement that by the undoped n-electrode side cladding layer, Fermi level ϕn is decreased and as a result ΔEc' is increased. It is possible, however, to confirm that the effect has been successfully attained or not, by evaluating the lifetime of the device.

[Example]

The LED as an example of the present invention having the structure shown in Fig. 14 was fabricated and the lifetimes of the example and of a conventional LED shown in Fig. 19 were measured. Conditions of lifetime test were the same as those of the examples in accordance with the first to third embodiments. As a result, it was found that the LED as the example of the present invention has its lifetime made longer by about 20 % in average than the comparative example.

(Fifth Embodiment)

Fig. 17 shows a light emitting device 10 in accordance with the fifth embodiment of the present invention. In the fourth embodiment described above, a structure has been described in which in an LED having the active layer sandwiched between cladding layers, the n-electrode side cladding layer is undoped. In the present embodiment, a structure will be described in which the n-electrode side cladding layer is undoped, and in addition, between active layer 4 and p-type cladding layer 5, a barrier layer 11 having a forbidden band width larger than that of the p-type cladding layer is interposed. The only difference over the light emitting device in accordance with the fourth embodiment is that barrier layer 11 having a forbidden band larger than that of the p-type cladding layer is interposed between active layer 4 and p-type cladding layer 5, and except for this point, the structure is the same as that of the light emitting device shown in Fig. 14.

In the LED having the above described structure, confinement of electrons is not governed by ΔEc but determined by ΔEc''. Therefore, it is expected that decrease in ϕn has a direct effect on suppressing the leakage of electrons.

An LED having such a structure as shown in Fig. 17 was actually fabricated and the lifetime was evaluated. As a result, it was confirmed that the lifetime could be made longer by about 30 % in average. Here, the forbidden band width of the cladding layer was set to 2.9 eV, and the forbidden band width of the barrier layer was set to 3.1 eV.

As described above, the main structural characteristic of the present invention is that the n-electrode side cladding layer is undoped. As to the allowable level of the residual carrier density, at least the density must be (1/2) of the hole density or lower in the p-type cladding layer, and the density of (1/10) or lower, if possible, is desired.

As an additional effect of not doping the n-electrode side cladding layer with any impurity, the purity of the active layer can be increased. When the n-electrode side cladding layer is doped with an n-type impurity, the n-type impurity remaining in the growth furnace tends to enter and mixed in the active layer, lowering the purity of the active layer. The lowering of the purity of the active layer may possibly decrease efficiency of light emission in the active layer, though it depends on the degree of purity lowering and the material type.

In the foregoing, ZnSe based LEDs have been described as examples. The present invention, however, is not limited to ZnSe based devices only, and preferable effects such as lower leakage current are expected to some degree or another, also in the light emitting devices using III-V group compound semiconductors, such GaAs or GaN. Further, the present structure is also effective not only in LEDs but also in LDs.

[Example]

An LED having the n-electrode side cladding layer doped to the n-type (comparative example) and an LED having the n-electrode side cladding layer undoped, that is not doped, (example of the invention) were fabricated as ZnSe based light emitting devices having the structure shown in Fig. 17. For the fabrication of the LEDs, an n-type ZnSe substrate having plane orientation of (100) was used, and on the substrate, the stacked structure shown in Fig. 17 was formed by the MBE method. As the n-type dopant, Cl was used, and as the p-type dopant, N was used. The band gap of the n-electrode side cladding layer was 2.9 eV. That of the p-electrode side cladding layer was 2.9 eV. Further, the band gap of the barrier layer was set to 3.1 eV. Further, Cd composition was adjusted such that light emission wavelength of active layer 4 attains to 485 nm. The thickness of each cladding layer was about 0.5 μm, and the thickness of the barrier layer was about 0.02 μm.

The carrier density of the n-electrode side cladding layer doped to the n-type (comparative example) was $2 \sim 3 \times 10^{17} cm^{-3}$, and the carrier density of the undoped n-electrode side cladding layer (present invention) was at most $2 \times 10^{15} cm^{-3}$. The carrier density of the p-type cladding layer was $3 \times 10^{16} cm^{-3}$, both in the example of the invention and in the comparative example.

Though not shown, after the barrier layer was formed, an n-electrode of Ti/Au was formed on the back side of the ZnSe substrate, and a semitransparent Au electrode having the thickness of about 100 Å was formed on the contact layer. Thereafter, the structure was scribe-broken to 400 μm × 400 μm, bonded on a stem, and an LED for lifetime evaluation was prepared.

Lifetimes of the LEDs as the example of the invention and as the comparative example fabricated in the above described manner were measured. As a method of measurement, a constant current of 15 mA was caused to flow at 70 °C and decrease in luminance was measured. The result was as follows.

In the LED as the comparative example, it took 200 to more than 500 hours until the luminance was decreased to 70 % of the initial luminance, and the average time was about 350 hours. In contrast, in the LED of the present invention, it took 350 to more than 650 hours until the luminance was decreased to 70 % of the initial luminance, and the average was about 450 hours. In other words, the LED as the example of the present invention has its lifetime made longer by about 30 % than the comparative example.

In the following, characteristics of these and other embodiments of the present invention will be described in a comprehensive manner.

The light emitting device of II-VI group compound semiconductor described above may be a ZnSe based light emitting device, in which the n-type cladding layer may be an n-type $Zn_{1-x}Mg_xS_ySe_{1-y}$ ($0 < x < 1$, $0 < y < 1$) layer, and the p-type cladding layer may be a p-type $Zn_{1-x}Mg_xS_ySe_{1-y}$ ($0 < x < 1$, $0 < y < 1$) layer. The aforementioned p-type $Zn_{1-x}Mg_xS_ySe_{1-y}$ is a compound semiconductor having a large band gap, and therefore, it can form a barrier, though not very effective, against the electrons that are about to enter from the trap layer to the p-type cladding layer. Therefore, the effect of elongating lifetime to some extent can be attained.

The magnitude of the band gap of the above described barrier layer should preferably be made larger by 0.025 eV to 0.5 eV than the p-type band gap.

When the band gap of the barrier layer is not larger by at least 0.025 eV than that of the p-type cladding layer, it is difficult to sufficiently suppress movement of electrons introduced to the active layer to the p-type cladding layer. When the band gap of the barrier layer is made larger by more than 0.5 eV, crystal becomes instable, affecting device characteristics.

In connection with the band gap of the barrier layer described above, the energy of the valence band thereof may be made approximately the same as that of the p-type cladding layer, and the energy of the conductive band thereof may be made larger than that of the p-type cladding layer.

By this structure, only the leakage of the electrons from the active layer to the p-type cladding layer is suppressed, and there is almost no influence on the holes in the valence band. Therefore, the lifetime can be made longer while not affecting the device characteristic.

The above described barrier layer may be formed of a II-VI group compound semiconductor including Be. By this structure, the lifetime of a ZnSe based light emitting device can be made longer without lowering light emission characteristics.

The above described barrier layer may be formed of $Zn_{1-x-y}Mg_xBe_ySe$ ($0 \leq x + y \leq 1$, $0 < x$, $0 < y$). In the II-VI group compound semiconductor including Be, particularly $Zn_{1-x-y}Mg_xBe_ySe$, it is possible to elevate the bottom of the conduction band without much changing the top of the valence band. Therefore, it is possible to form a barrier against electrons that tend to leak from the active layer to the p-type cladding layer while not presenting any barrier against holes moving from the side of the p-type cladding layer to the active layer and not hindering light emission caused by the introduction of holes. As a result, it becomes possible to elongate the lifetime of the device without degrading the light emission characteristics. Further, it is possible to form epitaxial barrier layer and p-type cladding layer, and therefore, high light emission efficiency can be attained. Though it is very difficult to introduce a p-type impurity to the $Zn_{1-x-y}Mg_xBe_ySe$ ($0.01 \leq y \leq 0.1$) layer mentioned above, if introduction of p-type impurity is possible, it may contain a p-type impurity, provided that it has a band gap larger than that of the p-type cladding layer.

The above described barrier layer may be formed of $Zn_{1-x}Mg_xS_ySe_{1-y}$ (x, y are in the range of 0~1).

By this structure, the band gap of the barrier layer can be made sufficiently larger than that of the p-type cladding layer, and entrance of electrons from the active layer to the p-type cladding layer can be prevented. As a result, longer lifetime of the light emitting device can be attained. The aforementioned $Zn_{1-x}Mg_xS_ySe_{1-y}$ (x, y are in the range of 0~1) layer should preferably be an i-type compound semiconductor. It may, however, contain a p-type impurity, provided that it has a band gap larger than that of the p-type cladding layer.

Further, between the above described barrier layer and the p-type cladding layer, a semiconductor trap layer may be provided that has a band gap smaller than the band gap of the p-type cladding layer.

By this structure, most of the electrons that have leaked over the barrier layer are trapped by defects in the trap layer or recombined with the holes before reaching the p-type cladding layer, and therefore, the number of electrons that reach the p-type cladding layer is significantly reduced. Even when the trap layer is of a p-type semiconductor, the band gap is smaller than that of the p-type cladding layer, and therefore, degradation proceeds slowly after the leaked electrons reach.

When the trap layer is provided, there results in a multi-stacked structure in which two such portions including the barrier layer and the trap layer are arranged between the active layer and the p-type cladding layer. By such multi-stacked structure, leakage of electrons to the p-type cladding layer can more surely be prevented, and the lifetime of the semiconductor light emitting device can further be made longer.

Further, the above described trap layer may be formed of $ZnS_xSe_{1-x}$ ($0 \leq x \leq 0.1$). When $ZnS_xSe_{1-x}$ ($0 \leq x \leq 0.1$) mentioned above is used, a trap layer having a band gap smaller than that of the p-type cladding layer can be epitaxially formed while maintaining good crystal characteristic. Further, this also enables good crystal characteristic of the epitaxial p-type cladding layer formed thereon. It is needless to say that $ZnS_xSe_{1-x}$ ($0 \leq x \leq 0.1$) mentioned above includes ZnSe.

The p-type cladding layer described above may be formed of $(Zn_{1-x}Cd_xS)_{1-z}(MgS_{1-y}Se_y)_z$ (where x, y, z satisfy $0 < x \leq 1$, $0 \leq y \leq 1$, $0 \leq z < 1$).

By adopting this structure in which a barrier layer is arranged between the active layer and the p-type cladding layer and the p-type cladding layer is formed of $(Zn_{1-x}Cd_xS)_{1-z}(MgS_{1-y}Se_y)_z$, lowering of luminance can be suppressed and the longer lifetime can be realized. When the p-type cladding layer is formed of other material such as p-type ZnMgSSe to have large band gap, the energy level at the bottom of the conductive band is elevated, while the energy level at the upper end of the valence band lowers. Therefore, though the band gap becomes large and the barrier potential against leaked electrons can be formed, a barrier potential is also formed against the holes that are to be introduced from the p-type cladding layer through the barrier layer to the active layer. This causes lowering of luminance of the light emitting device.

The composition x of the p-type cladding layer is determined such that the lattice constant of $Zn_{1-x}Cd_xS$ matches the lattice constant of the semiconductor substrate. Further, the composition y is determined such that the lattice constant of $MgS_{1-y}Se_y$ matches the lattice constant of the semiconductor substrate.

If the band gap of the ZnMgSSe layer used as the common p-type cladding layer were increased along with the increase in the band gap of the barrier layer, the barrier against holes would not be formed. When the band gap of the ZnMgSSe layer were made too large, however, p-type doping would become difficult. When Cd is contained in the p-type cladding layer as described above, the energy level at the upper end of the valence band becomes lower than when Cd is not contained, with the same band gap. Therefore, the barrier against holes is not formed but rather, introduction of holes to the side of the active layer is facilitated. Therefore, degradation in luminance can be suppressed. When Cd is contained in the material for forming the p-type cladding layer, energy level of not only the valence band but also of the conductive band is decreased, and therefore, sufficient confinement of electrons cannot be attained by the p-type cladding layer only. For this reason, a barrier layer having a band gap larger than that of the p-type cladding layer is combined as described above, so as to make the most of the effect attained by forming the p-type cladding layer of $(Zn_{1-x}Cd_xS)_{1-z}(MgS_{1-y}Se_y)_z$.

The thickness of the barrier layer described above may be in the range of at least 5 nm and at most the thickness of the active layer. When the thickness of the barrier layer is smaller than 5 nm, electrons in the active layer flow into the p-type cladding layer because of the tunneling effect, and the function as a barrier potential is hardly exhibited. When the thickness exceeds the thickness of the active layer, rigidity of the barrier layer increases, distortion matching would be lost and large distortion would result. As the upper limit of the thickness of the barrier layer, the thickness of the active layer may be used, or a specific value of 100 nm may be separately set as the upper limit.

As the compound semiconductor substrate described above, an n-type ZnSe single crystal substrate may be used. Using this substrate, it becomes possible to form an epitaxial film with good crystal characteristic, and to fabricate a light emitting device having good light emission efficiency and long lifetime.

As the compound semiconductor substrate described above, an n-type GaAs single crystal substrate may be used. A GaAs substrate is inexpensive, and it also allows formation of a ZnSe based epitaxial film. Therefore, an inexpensive light emitting device having long lifetime and good light emitting efficiency can be obtained. Further, when the n-type GaAs single crystal substrate is used as the compound semiconductor substrate, it is possible to obtain a large number of semiconductor light emitting devices of a prescribed performance level or higher efficiently at a low cost. When an n-type GaAs single crystal substrate is used, it is preferred to use ZnSSe containing S for the trap layer, from the relation with the lattice constant of the crystal.

In the stacked structure including the compound semiconductor substrate constituting the ZnSe based light emitting device described above, deviation between the peak of X-ray diffraction of the plane orientation used as an index of distortion from the substrate and the peak of x-ray diffraction of the plane orientation from the stacked structure may be at most 1000 seconds.

By this structure, it is possible to obtain a ZnSe based light emitting device having long lifetime and superior light emitting characteristics, as the deviation mentioned above is suppressed. The plane index used as an index of distortion of a compound semiconductor substrate is, generally, (400) plane. Suppression of the deviation described above leads to suppression of distortion generated in the light emitting device.

In the embodiments above, only a p-type semiconductor layer has been described as the trap layer. The trap layer, however, may be an undoped layer substantially containing no impurity (though it may contain residual impurity, regardless of p-type or n-type). Though an impurity was not mentioned in relation with the barrier layer, the barrier layer may be an undoped layer substantially containing no impurity (though it may contain residual impurity, regardless of p-type or n-type).

Magnitude relation of the thickness of trap layer and barrier layer need not specifically be limited. Functionally, however, the trap layer should preferably be thicker than the barrier layer, as the barrier layer forms a potential barrier and the trap layer traps the electrons that are moving.

Though description ofLEDs only has been made in the embodiments above, the present invention is applicable to any light emitting device that uses II-VI group compound semiconductor. By way of example, the present invention may be applied to an LD, especially green LD.

Though an impurity of the barrier layer is not mentioned in the embodiments above, the barrier layer may be an undoped layer substantially containing no impurity (though it may contain residual impurity, regardless of p-type or n-type), or it may contain an impurity to attain p-type conductivity.

In the above described semiconductor light emitting device in which the other cladding layer is of an undoped semiconductor, the impurity concentration remaining in the undoped semiconductor may be smaller than $1 \times 10^{16}/cm^3$.

By the above described structure, it becomes possible to suppress impurity concentration remaining in the undoped semiconductor to be low and to decrease Fermi level of the electrons in the active layer. As a result, leakage of electrons from the active layer to the p-type cladding layer can be suppressed.

Between the active layer described above and the cladding layer to which a p-type impurity has been introduced (p-type cladding layer), a barrier layer having a band gap larger than the band gap (forbidden band) of the p-type cladding layer may be positioned.

In the above-described structure provided with the barrier layer, the undoped semiconductor lowers Fermi level of electrons in the active layer, and the barrier layer can form a higher barrier against the electrons in the active layer.

The above described semiconductor may be a II-VI group compound semiconductor.

By this structure, in the p-type cladding layer of a light emitting device formed of the II-VI group compound semiconductor, generation of donor-related defects caused by recombination of electrons and holes can be suppressed.

The semiconductor may be a ZnSe based compound semiconductor.

By this structure, when a light emitting device is formed using the ZnSe based compound semiconductor that is highly sensitive to generation of the aforementioned donor-related defects, in the p-type cladding layer of the light emitting device, generation of donor-related defects caused by recombination of electrons and holes can be suppressed.

The above described two cladding layers may be formed of ZnMgSSe.

By this structure, the band gap of the cladding layer is surely made larger than the band gap of the active layer, and the leakage of electrons from the active layer to the p-type cladding layer can be suppressed to be not higher than a prescribed amount.

The above described barrier layer may be formed of ZnMgBeSe.

As ZnMgBeSe is used as a material of the barrier layer, the band gap becomes larger than that of the cladding layer, and as a result of this larger band gap, the energy level at the bottom of the conductive band is elevated (in other words, electron affinity lowers). Therefore, leakage of electrons to the p-type cladding layer can be suppressed. Compared with ZnMgSSe, ZnMgBeSe is known to attain smaller electron affinity, and therefore, if the band gap is the same, ZnMgBeSe is more preferable as it attains higher efficiency of electron confinement. Further, ZnMgBeSe increases energy value of the conductive band while it hardly has an influence on the valence band, and therefore, it does not prevent introduction of holes from the p-type cladding layer to the active layer.

Although the present invention has been described and illustrated in detail, it is clearly understood that the same is by way of illustration and example only and is not to be taken by way of limitation, the spirit and scope of the present invention being limited only by the terms of the appended claims.

## Claims

**1.** A light emitting device of a II-VI group compound semiconductor formed on a compound semiconductor substrate and having an active layer (4) between an n-type cladding layer (3) and a p-type cladding layer (5), comprising
a semiconductor barrier layer (11) having a band gap larger than a band gap of said p-type cladding layer, provided between said active layer and said p-type cladding layer.

**2.** The semiconductor light emitting device according to claim 1, wherein
said light emitting device of the II-VI group compound is a ZnSe based light emitting device;
said n-type cladding layer (3) is an n-type $Zn_{1-x}Mg_xS_ySe_{1-y}$ ($0 < x < 1$, $0 < y < 1$) layer; and
said p-type cladding layer (5) is a p-type $Zn_{1-x}Mg_xS_ySe_{1-y}$ ($0 < x < 1$, $0 < y < 1$) layer.

**3.** The semiconductor light emitting device according to claim 1, wherein
magnitude of the band gap of said barrier layer (11) is larger by 0.025 eV to 0.5 eV than the band gap of said p-type cladding layer.

**4.** The semiconductor light emitting device according to claim 1, wherein
in the band gap of said barrier layer, energy of valence band is approximately the same as that of said p-type cladding layer, and energy of conductive band is larger than that of said p-type cladding layer.

**5.** The semiconductor light emitting device according to claim 1, wherein
said barrier layer is of a II-VI group compound semiconductor containing Be.

**6.** The semiconductor light emitting device according to claim 5, wherein
said barrier layer is of $Zn_{1-x-y}Mg_xBe_ySe$ ($0 \leq x + y \leq 1$, $0 < x$, $0 < y$).

**7.** The semiconductor light emitting device according to claim 1, wherein
said barrier layer is of $Zn_{1-x}Mg_xS_ySe_{1-y}$.

**8.** The semiconductor light emitting device according to claim 1, comprising
a semiconductor trap layer (12) having a band gap smaller than a band gap of said p-type cladding layer, provided between said barrier layer and said p-type cladding layer.

**9.** The semiconductor light emitting device according to claim 8, having a multi-stacked structure in which a plurality of double-layer-structure of said barrier layer (11) and said trap layer (12) are stacked.

**10.** The semiconductor light emitting device according to claim 8, wherein
said trap layer is of $ZnS_xSe_{1-x}$ ($0 \leq x \leq 0.1$).

**11.** The semiconductor light emitting device according to claim 1, wherein
said p-type cladding layer is formed of $(Zn_{1-x}Cd_xS)_{1-z}(MgS_{1-y}Se_y)_z$ (where x, y, z satisfy $0 < x \leq 1$, $0 \leq y \leq 1$, $0 \leq z < 1$).

**12.** The semiconductor light emitting device according to claim 1, wherein

thickness of said barrier layer is at least 5 nm and at most thickness of said active layer.

**13.** The semiconductor light emitting device according to claim 1, wherein
an n-type ZnSe single crystal substrate (1) is used as said compound semiconductor substrate.

**14.** The semiconductor light emitting device according to claim 1, wherein
an n-type GaAs single crystal substrate (1) is used as said compound semiconductor substrate.

**15.** The semiconductor light emitting device according to claim 1, wherein
in a stacked structure including said compound semiconductor substrate (1) constituting said ZnSe based light emitting device, deviation between a peak of X-ray diffraction of a plane orientation used as an index of distortion from said substrate and a peak of X-ray diffraction of said plane orientation from said stacked structure is at most 1000 seconds.

**16.** A semiconductor light emitting device formed on a compound semiconductor substrate, having an active layer sandwiched between two cladding layers, wherein
one of said two cladding layers is a p-type semiconductor to which a p-type impurity is introduced; and
the other cladding layer is an undoped semiconductor.

**17.** The semiconductor light emitting device according to claim 16, wherein
concentration of residual impurity in said undoped semiconductor is smaller than $1 \times 10^{16}/cm^3$.

**18.** The semiconductor light emitting device according to claim 16, wherein
between said active layer and said cladding layer of p-type semiconductor (p-type cladding layer), a barrier layer having a band gap (forbidden band) larger than that of said p-type cladding layer is positioned.

**19.** The semiconductor light emitting device according to claim 18, wherein
said barrier layer is formed of $Zn_{1-x-y}Mg_xBe_ySe$ ($0 \leq x + y \leq 1$, $0 < x$, $0 < y$).

**20.** The semiconductor light emitting device according to claim 16, wherein
said semiconductor is a II-VI group compound semiconductor.

**21.** The semiconductor light emitting device according to claim 20, wherein
said semiconductor is a ZnSe based compound semiconductor.

**22.** The semiconductor light emitting device according to claim 16, wherein
said two cladding layers are formed of $Zn_{1-x}Mg_xS_ySe_{1-y}$.

FIG.1

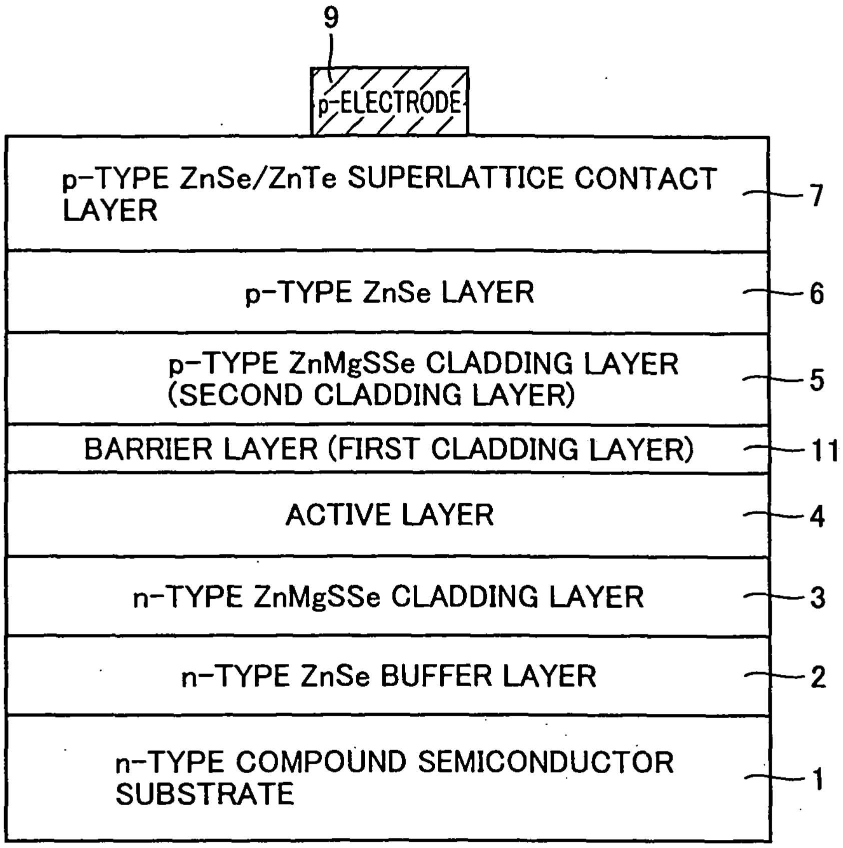
9
p-ELECTRODE
p-TYPE ZnSe/ZnTe SUPERLATTICE CONTACT LAYER
7
p-TYPE ZnSe LAYER
6
p-TYPE ZnMgSSe CLADDING LAYER (SECOND CLADDING LAYER)
5
BARRIER LAYER (FIRST CLADDING LAYER)
11
ACTIVE LAYER
4
n-TYPE ZnMgSSe CLADDING LAYER
3
n-TYPE ZnSe BUFFER LAYER
2
n-TYPE COMPOUND SEMICONDUCTOR SUBSTRATE
1

FIG.2

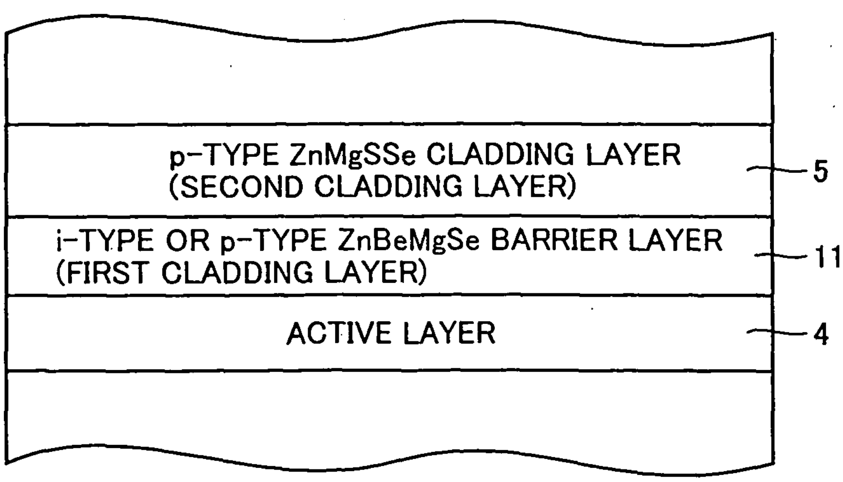
p-TYPE ZnMgSSe CLADDING LAYER (SECOND CLADDING LAYER)
5
i-TYPE OR p-TYPE ZnBeMgSe BARRIER LAYER (FIRST CLADDING LAYER)
11
ACTIVE LAYER
4

FIG.3

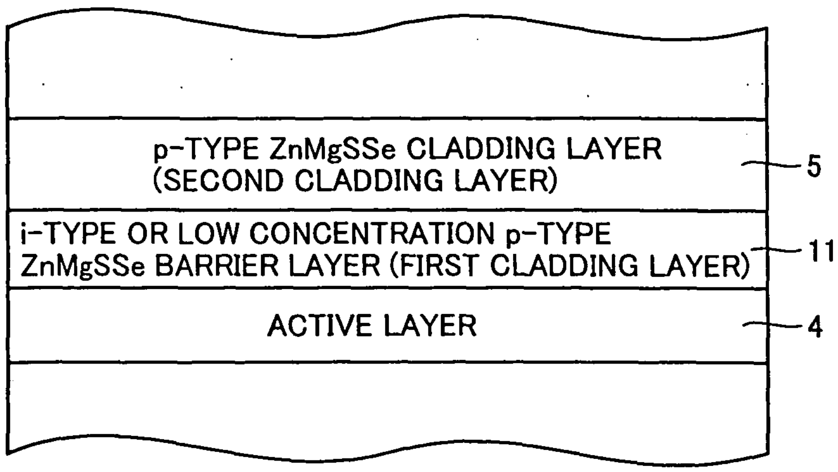
p-TYPE ZnMgSSe CLADDING LAYER
(SECOND CLADDING LAYER)
5
i-TYPE OR LOW CONCENTRATION p-TYPE
ZnMgSSe BARRIER LAYER (FIRST CLADDING LAYER)
11
ACTIVE LAYER
4

FIG.4

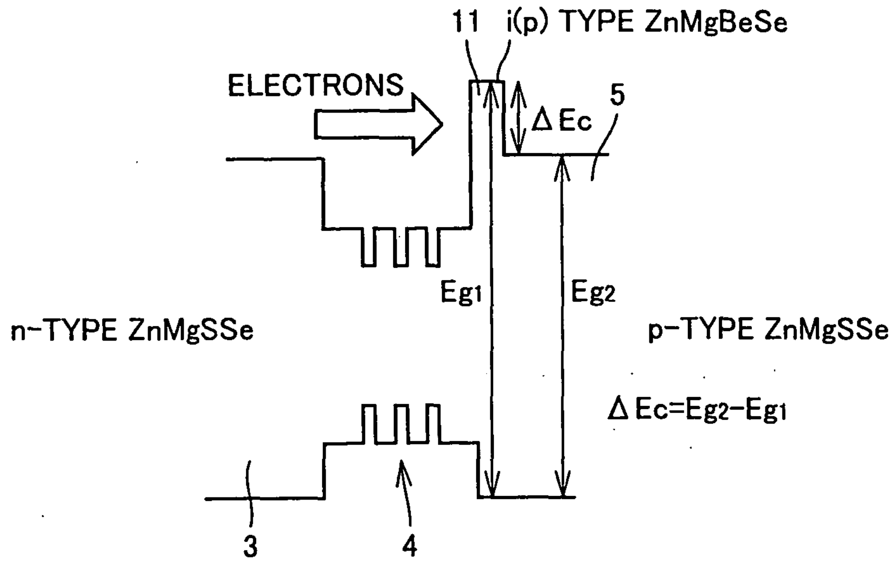
11 i(p) TYPE ZnMgBeSe
ELECTRONS
ΔEc
5
Eg1
Eg2
n-TYPE ZnMgSSe
p-TYPE ZnMgSSe
ΔEc=Eg2-Eg1
3
4

FIG.5

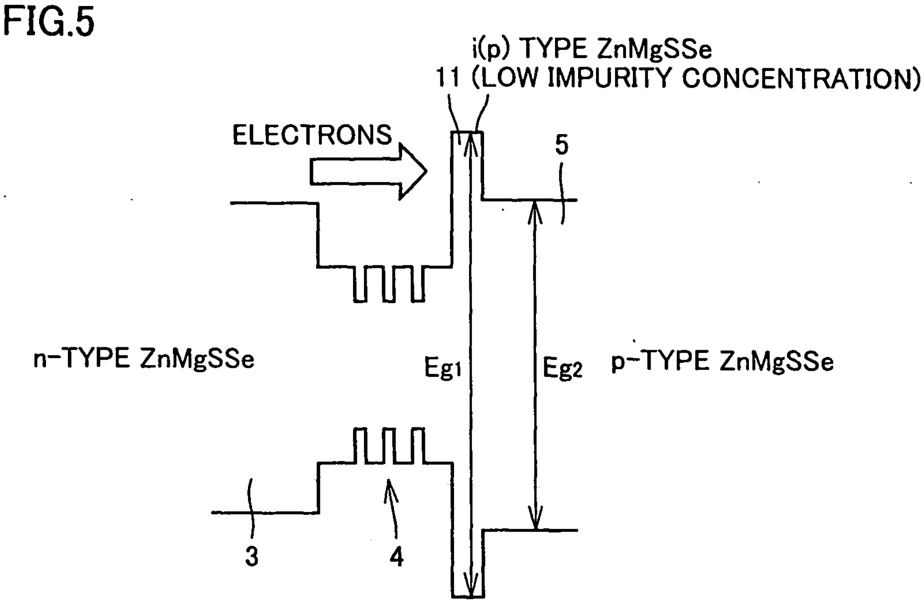
i(p) TYPE ZnMgSSe
11 (LOW IMPURITY CONCENTRATION)
ELECTRONS
5
n-TYPE ZnMgSSe
Eg1
Eg2
p-TYPE ZnMgSSe
3
4

FIG.6

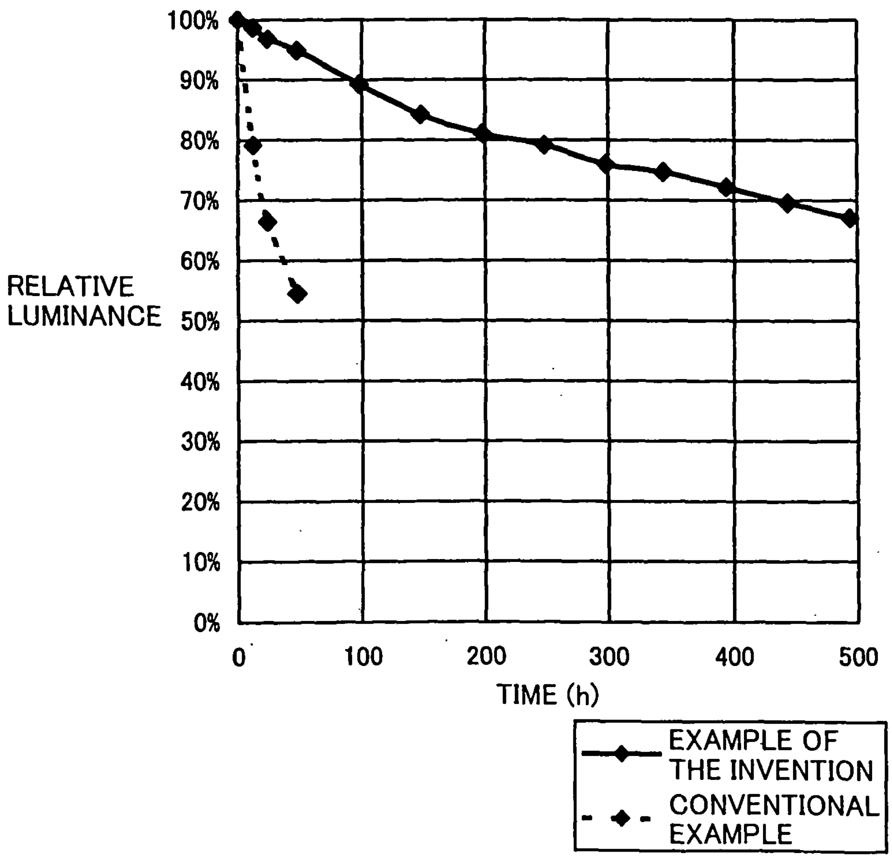
100%
90%
80%
70%
60%
RELATIVE LUMINANCE
50%
40%
30%
20%
10%
0%
0
100
200
300
400
500
TIME (h)
EXAMPLE OF THE INVENTION
CONVENTIONAL EXAMPLE

FIG.7

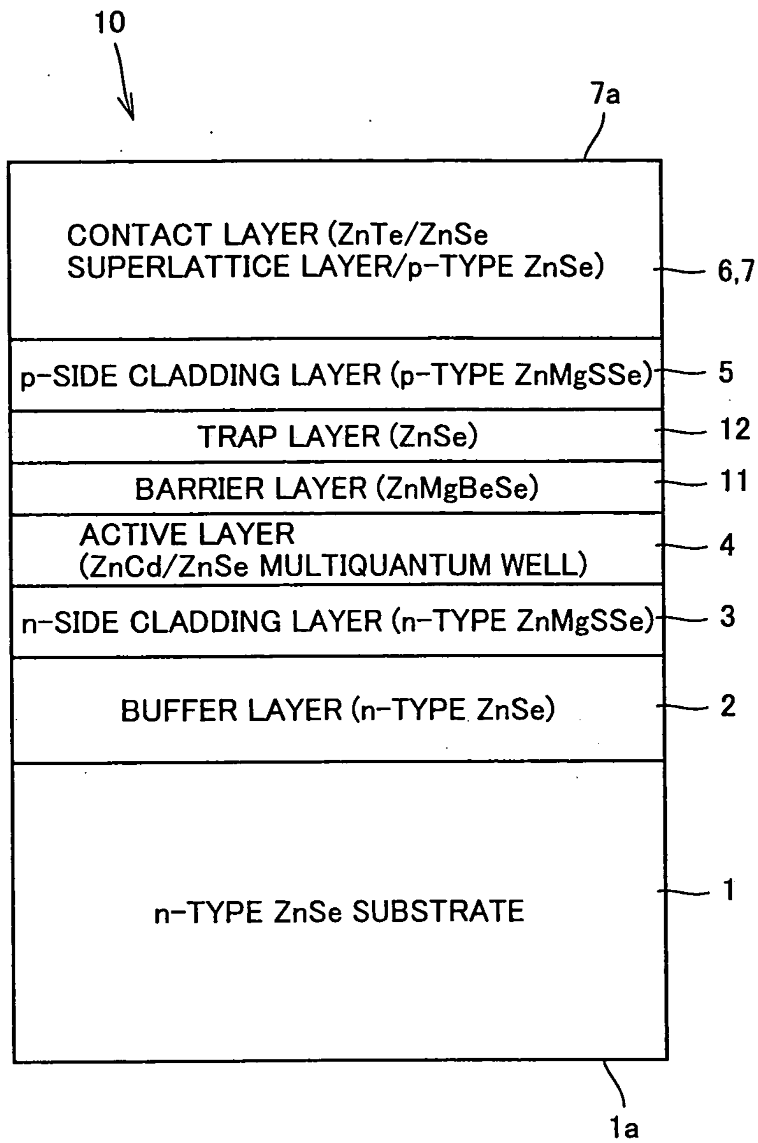
10
7a
CONTACT LAYER (ZnTe/ZnSe SUPERLATTICE LAYER/p-TYPE ZnSe)
6,7
p-SIDE CLADDING LAYER (p-TYPE ZnMgSSe)
5
TRAP LAYER (ZnSe)
12
BARRIER LAYER (ZnMgBeSe)
11
ACTIVE LAYER (ZnCd/ZnSe MULTIQUANTUM WELL)
4
n-SIDE CLADDING LAYER (n-TYPE ZnMgSSe)
3
BUFFER LAYER (n-TYPE ZnSe)
2
n-TYPE ZnSe SUBSTRATE
1
1a

FIG.8

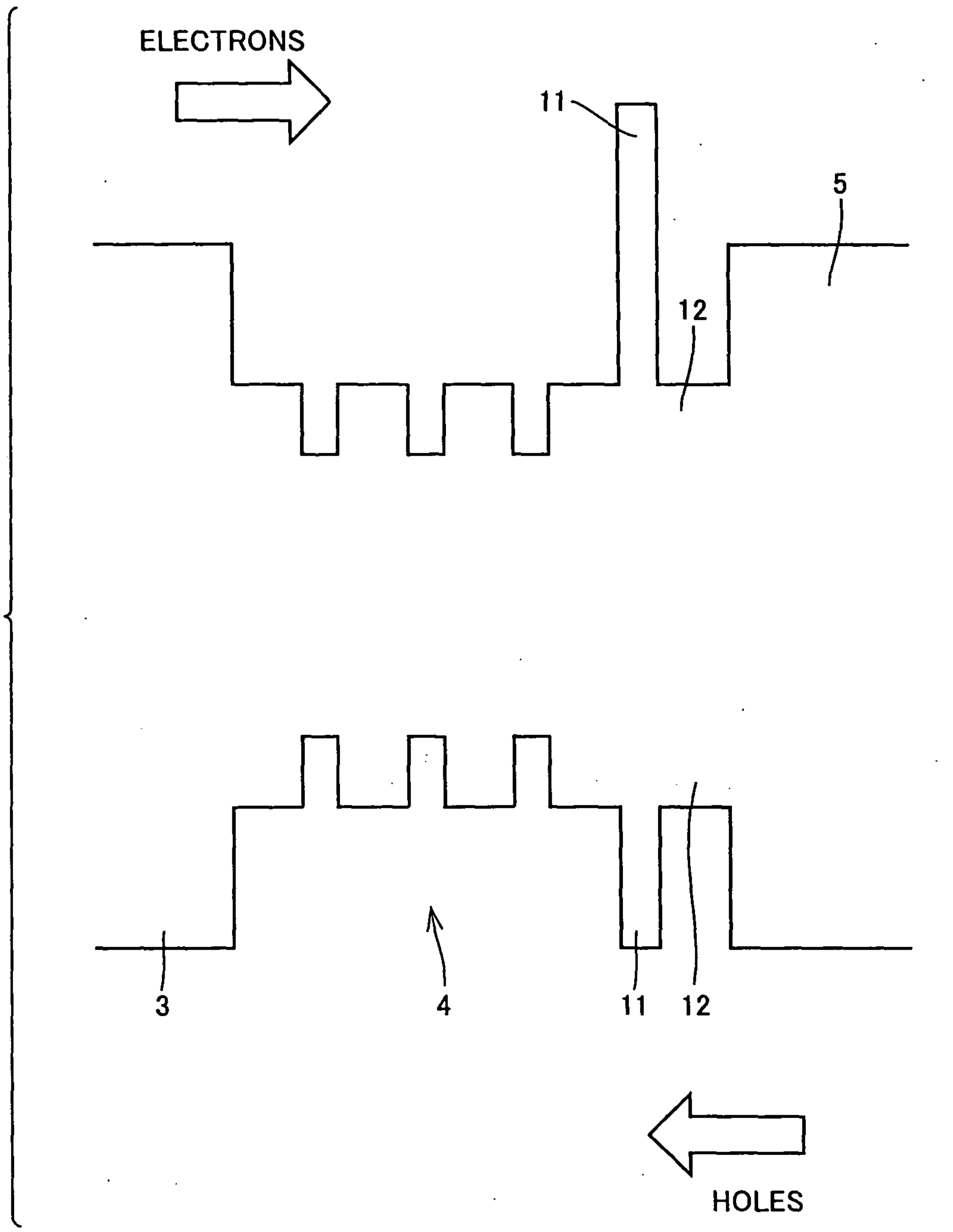

FIG.9

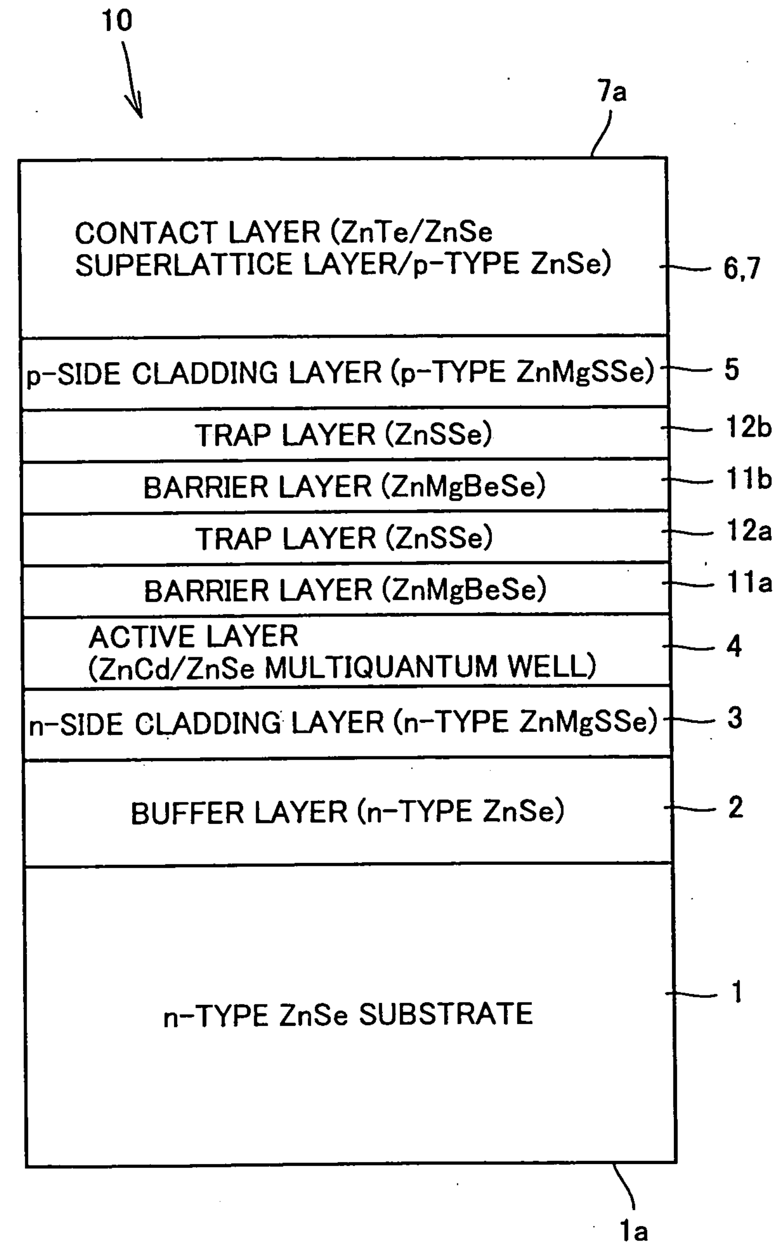
10
7a
CONTACT LAYER (ZnTe/ZnSe SUPERLATTICE LAYER/p-TYPE ZnSe)
6,7
p-SIDE CLADDING LAYER (p-TYPE ZnMgSSe)
5
TRAP LAYER (ZnSSe)
12b
BARRIER LAYER (ZnMgBeSe)
11b
TRAP LAYER (ZnSSe)
12a
BARRIER LAYER (ZnMgBeSe)
11a
ACTIVE LAYER (ZnCd/ZnSe MULTIQUANTUM WELL)
4
n-SIDE CLADDING LAYER (n-TYPE ZnMgSSe)
3
BUFFER LAYER (n-TYPE ZnSe)
2
n-TYPE ZnSe SUBSTRATE
1
1a

FIG.10

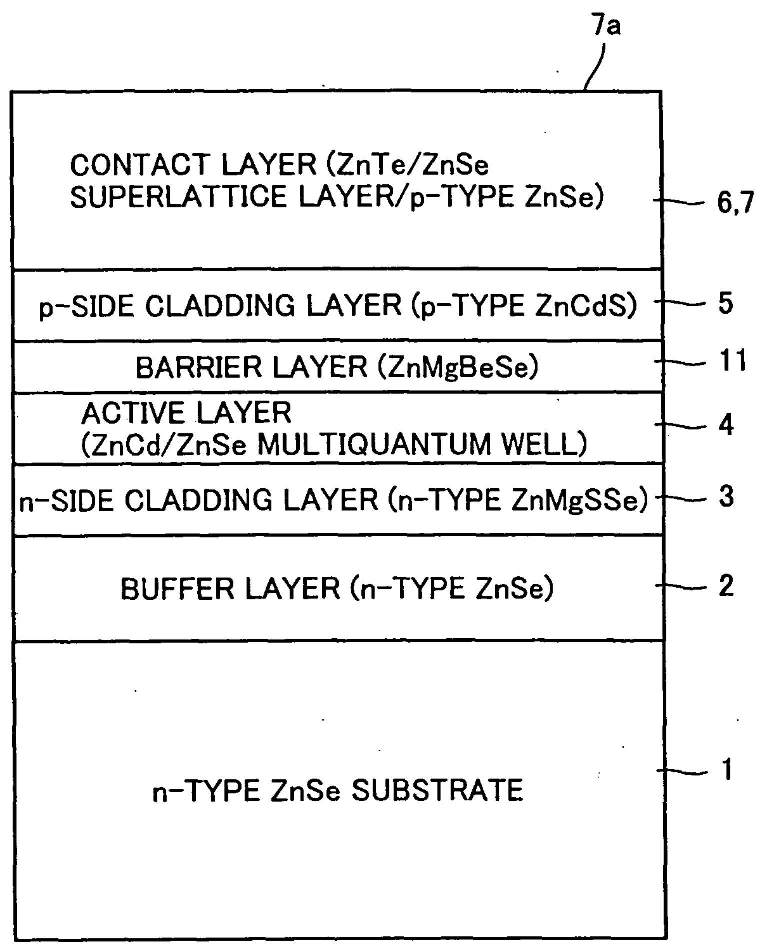
7a
CONTACT LAYER (ZnTe/ZnSe SUPERLATTICE LAYER/p-TYPE ZnSe)
6,7
p-SIDE CLADDING LAYER (p-TYPE ZnCdS)
5
BARRIER LAYER (ZnMgBeSe)
11
ACTIVE LAYER (ZnCd/ZnSe MULTIQUANTUM WELL)
4
n-SIDE CLADDING LAYER (n-TYPE ZnMgSSe)
3
BUFFER LAYER (n-TYPE ZnSe)
2
n-TYPE ZnSe SUBSTRATE
1

FIG.11

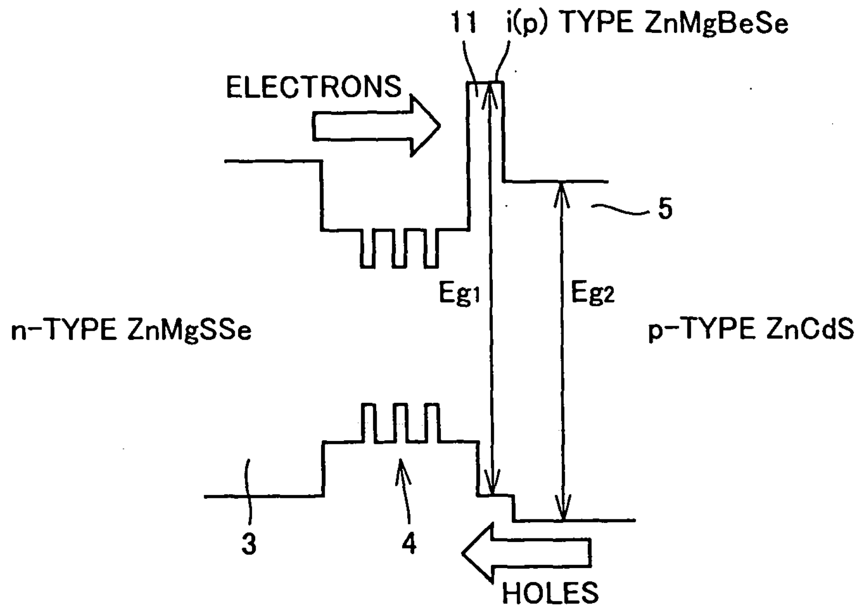
11
i(p) TYPE ZnMgBeSe
ELECTRONS
5
Eg1
Eg2
n-TYPE ZnMgSSe
p-TYPE ZnCdS
3
4
HOLES

FIG.12

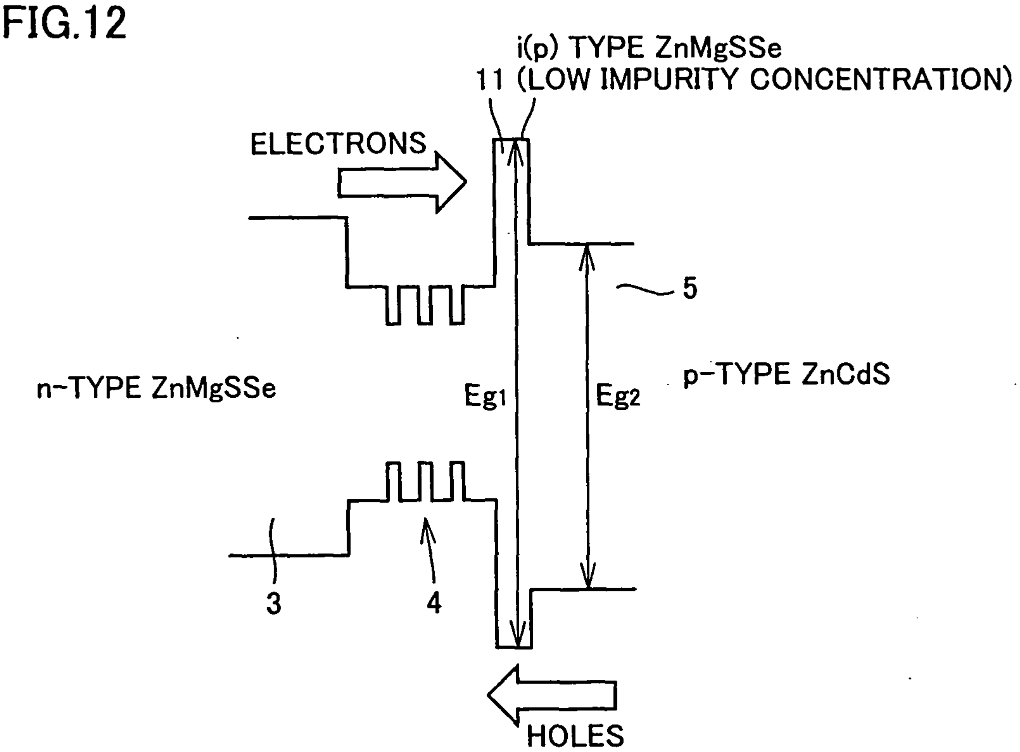
i(p) TYPE ZnMgSSe
11 (LOW IMPURITY CONCENTRATION)
ELECTRONS
5
Eg1
Eg2
n-TYPE ZnMgSSe
p-TYPE ZnCdS
3
4
HOLES

FIG.13

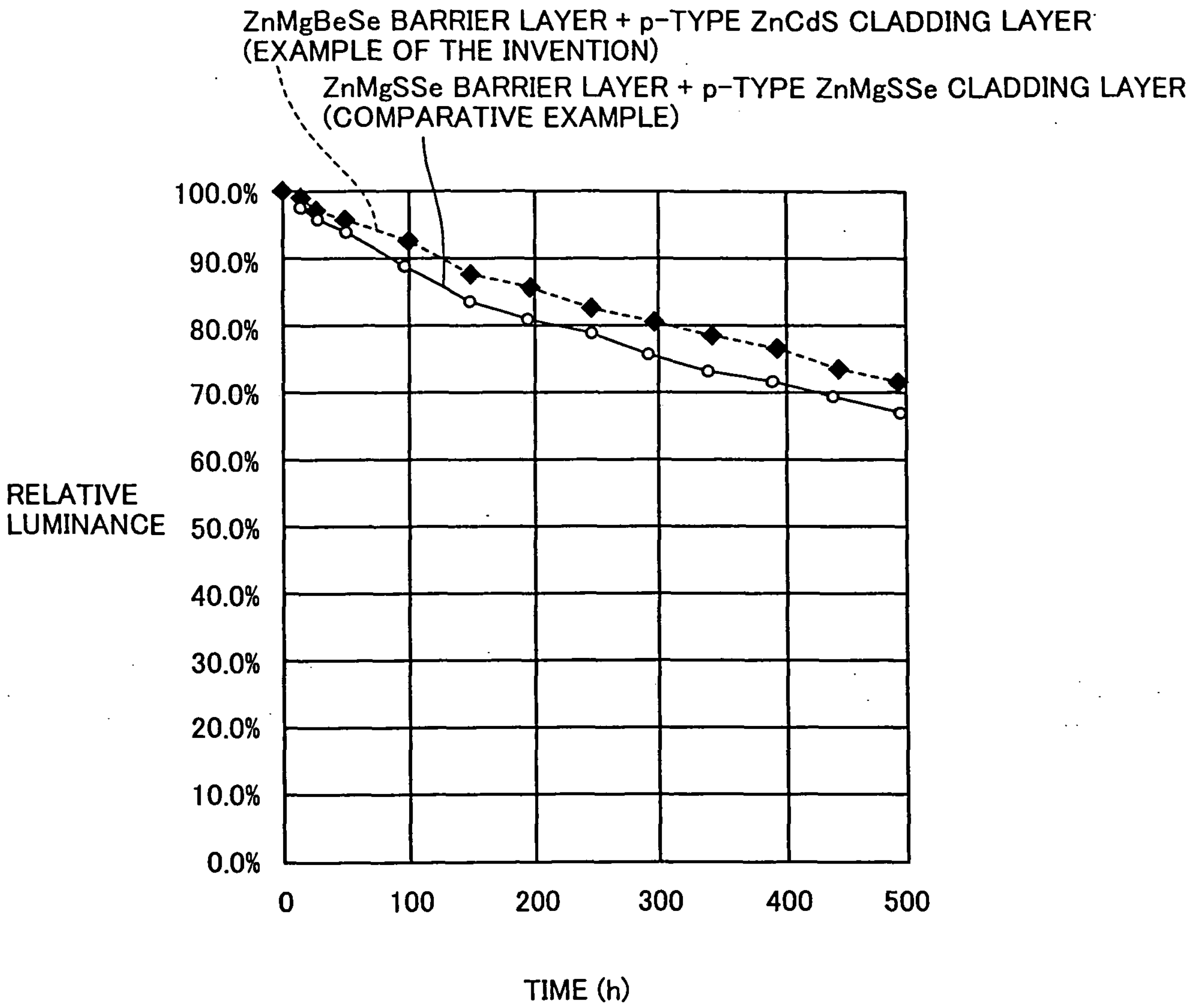
ZnMgBeSe BARRIER LAYER + p-TYPE ZnCdS CLADDING LAYER
(EXAMPLE OF THE INVENTION)
ZnMgSSe BARRIER LAYER + p-TYPE ZnMgSSe CLADDING LAYER
(COMPARATIVE EXAMPLE)
RELATIVE LUMINANCE
100.0%
90.0%
80.0%
70.0%
60.0%
50.0%
40.0%
30.0%
20.0%
10.0%
0.0%
0
100
200
300
400
500
TIME (h)

FIG.14

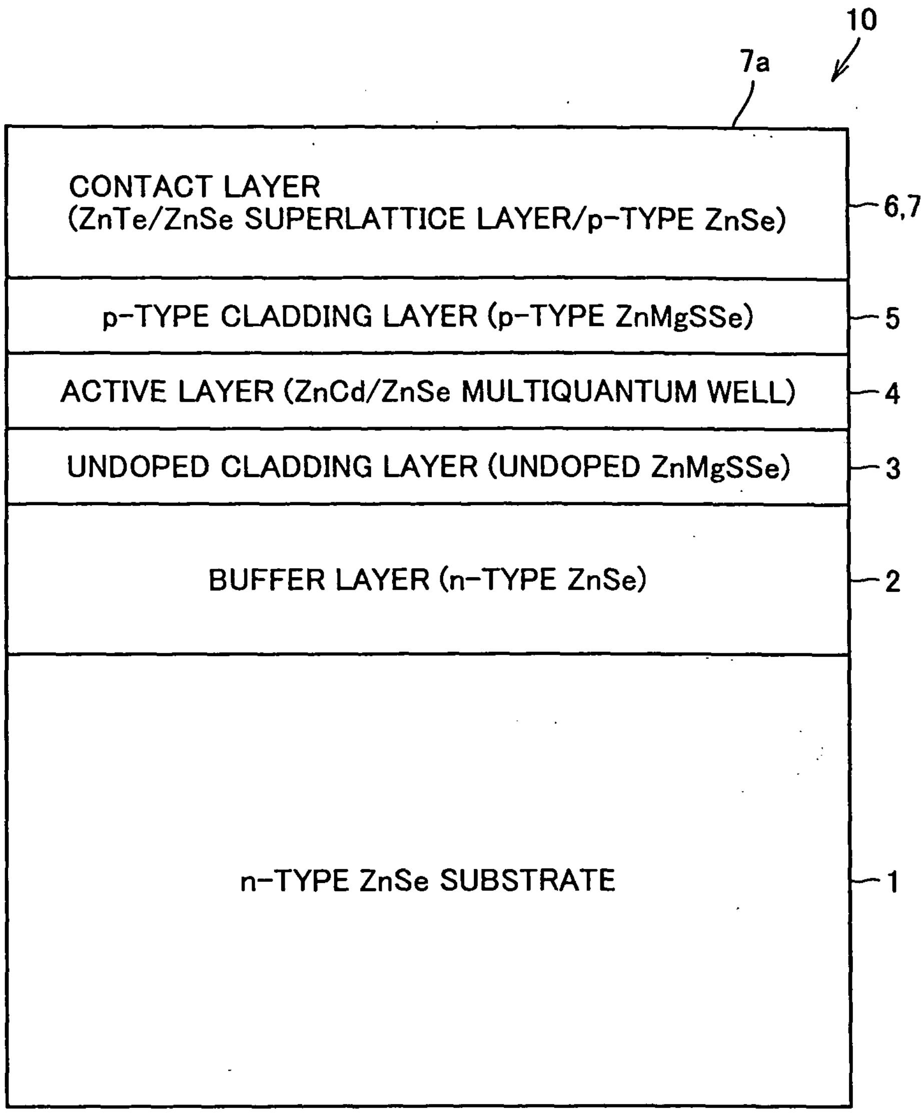
10
7a
CONTACT LAYER
(ZnTe/ZnSe SUPERLATTICE LAYER/p-TYPE ZnSe)
6,7
p-TYPE CLADDING LAYER (p-TYPE ZnMgSSe)
5
ACTIVE LAYER (ZnCd/ZnSe MULTIQUANTUM WELL)
4
UNDOPED CLADDING LAYER (UNDOPED ZnMgSSe)
3
BUFFER LAYER (n-TYPE ZnSe)
2
n-TYPE ZnSe SUBSTRATE
1

FIG.15

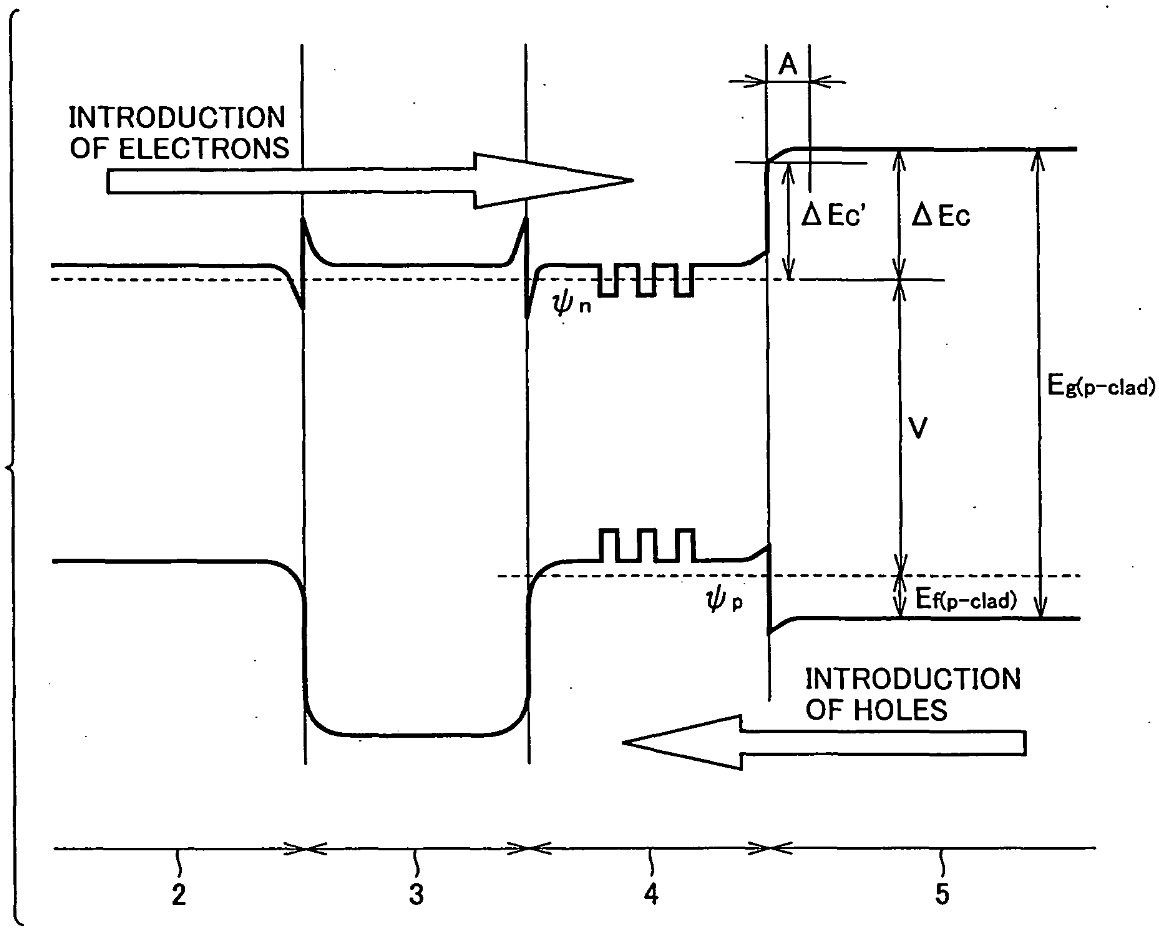
INTRODUCTION OF ELECTRONS
A
ΔEc'
ΔEc
ψn
Eg(p-clad)
V
ψp
Ef(p-clad)
INTRODUCTION OF HOLES
2
3
4
5

FIG.16

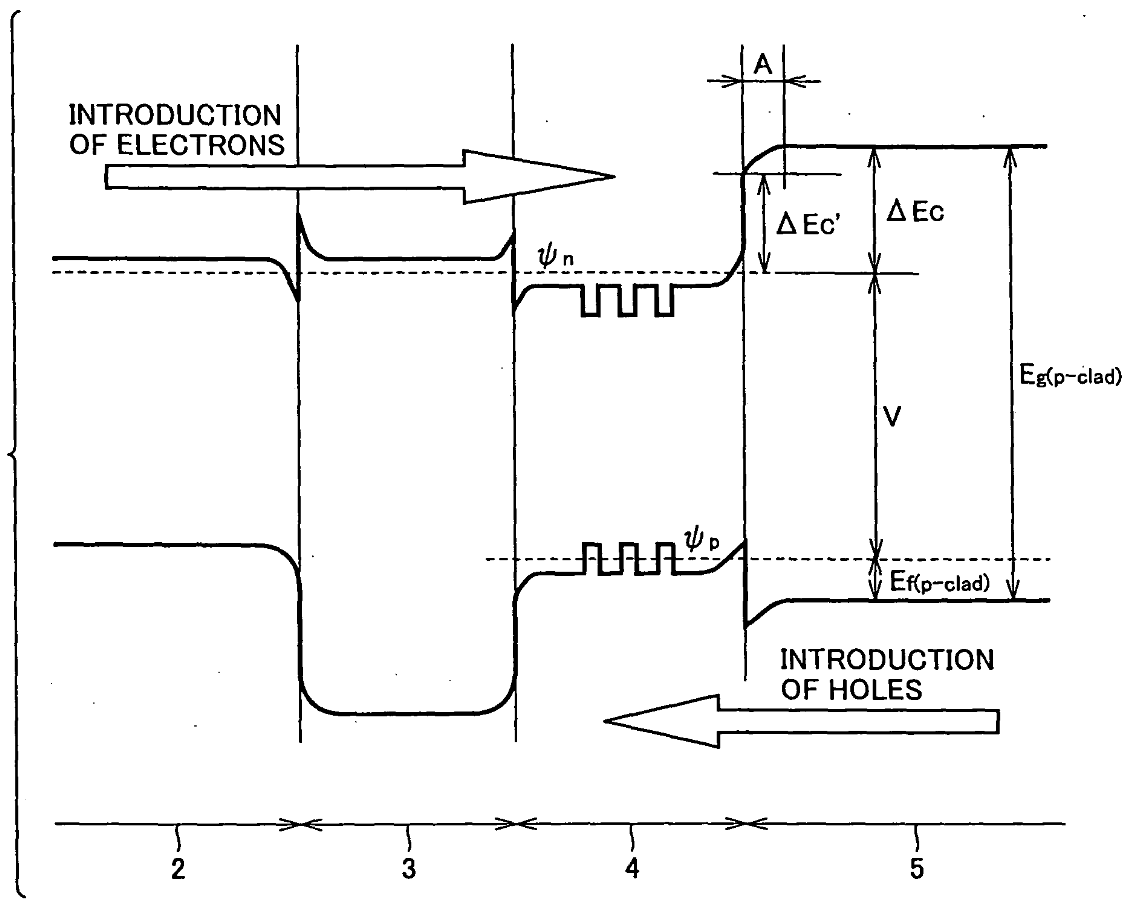
INTRODUCTION
OF ELECTRONS
A
ΔEc'
ΔEc
ψn
Eg(p-clad)
V
ψp
Ef(p-clad)
INTRODUCTION
OF HOLES
2
3
4
5

FIG.17

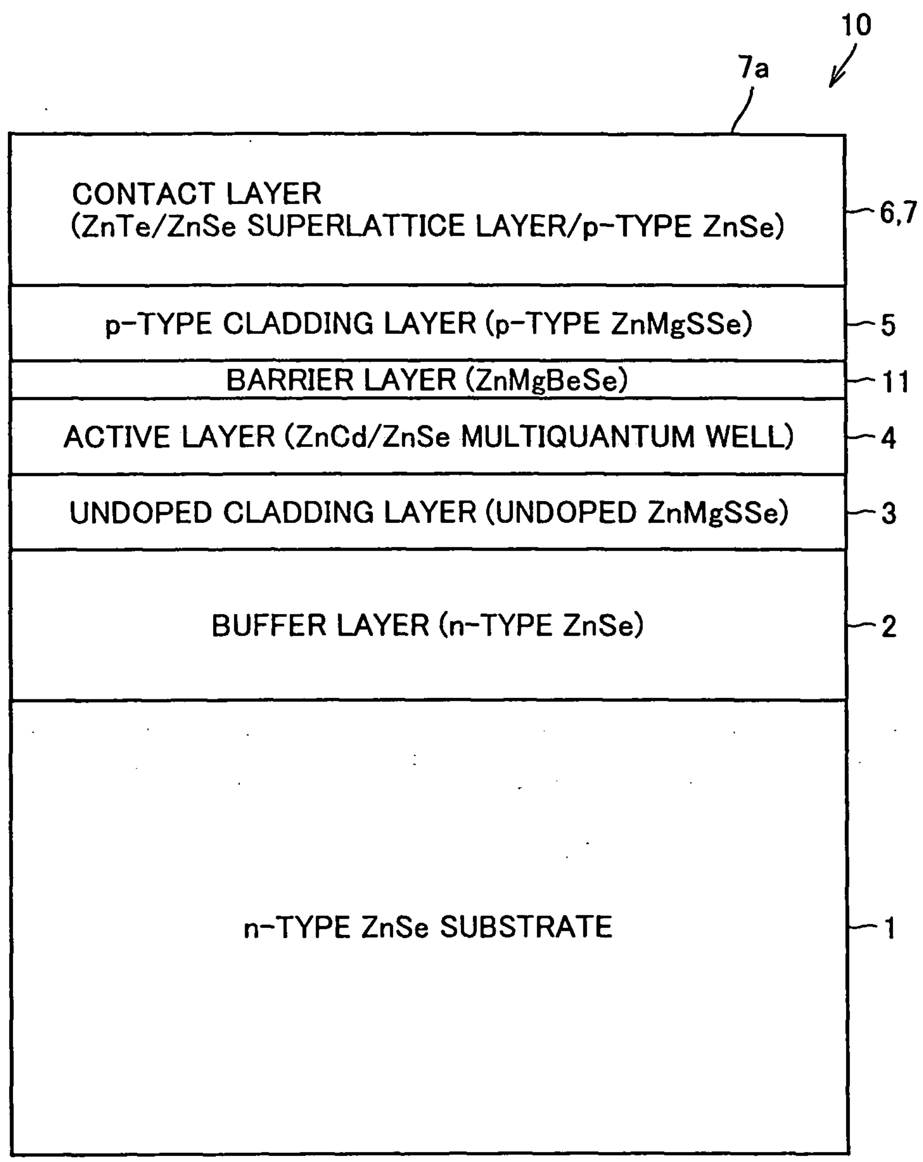
10
7a
CONTACT LAYER
(ZnTe/ZnSe SUPERLATTICE LAYER/p-TYPE ZnSe)
6,7
p-TYPE CLADDING LAYER (p-TYPE ZnMgSSe)
5
BARRIER LAYER (ZnMgBeSe)
11
ACTIVE LAYER (ZnCd/ZnSe MULTIQUANTUM WELL)
4
UNDOPED CLADDING LAYER (UNDOPED ZnMgSSe)
3
BUFFER LAYER (n-TYPE ZnSe)
2
n-TYPE ZnSe SUBSTRATE
1

FIG.18

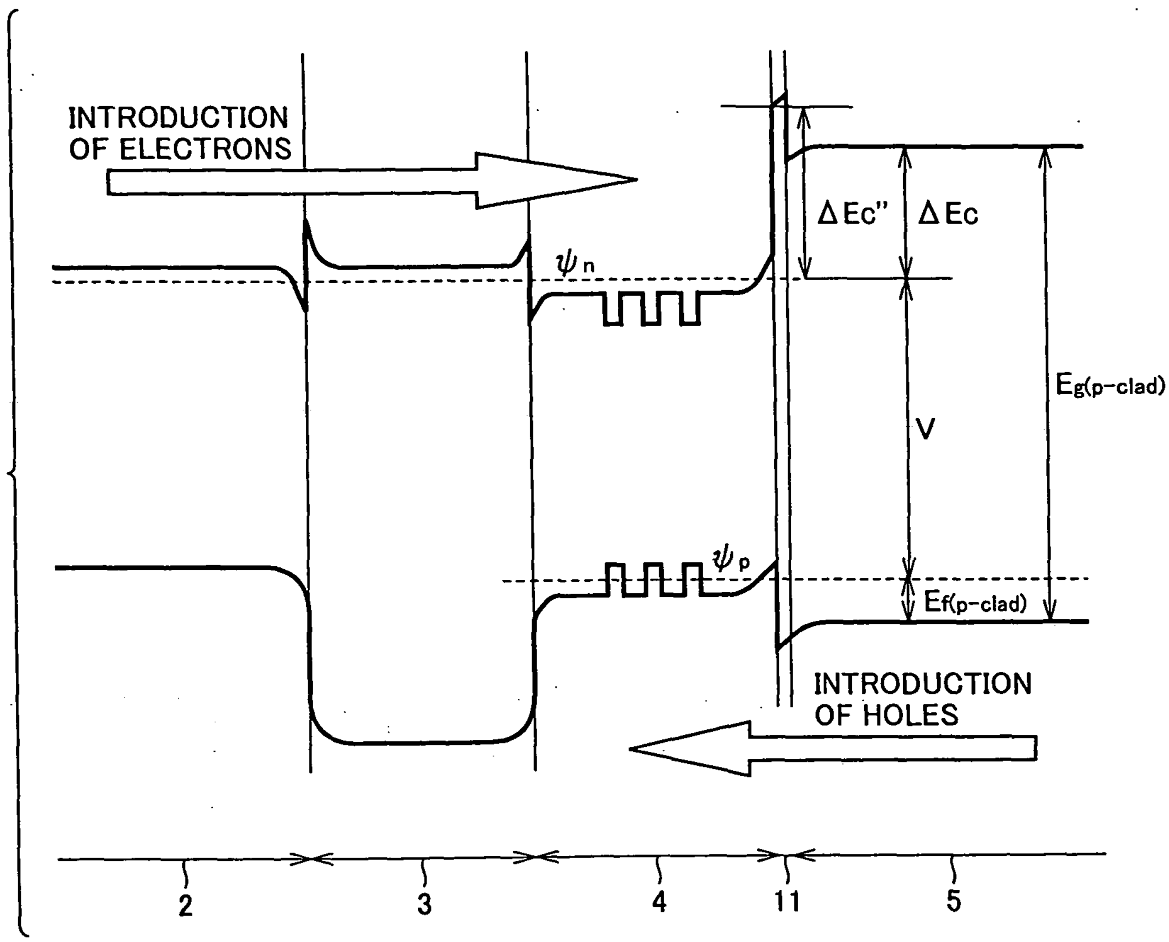
INTRODUCTION
OF ELECTRONS
ψn
ΔEc"
ΔEc
Eg(p-clad)
V
ψp
Ef(p-clad)
INTRODUCTION
OF HOLES
2
3
4
11
5

FIG.19

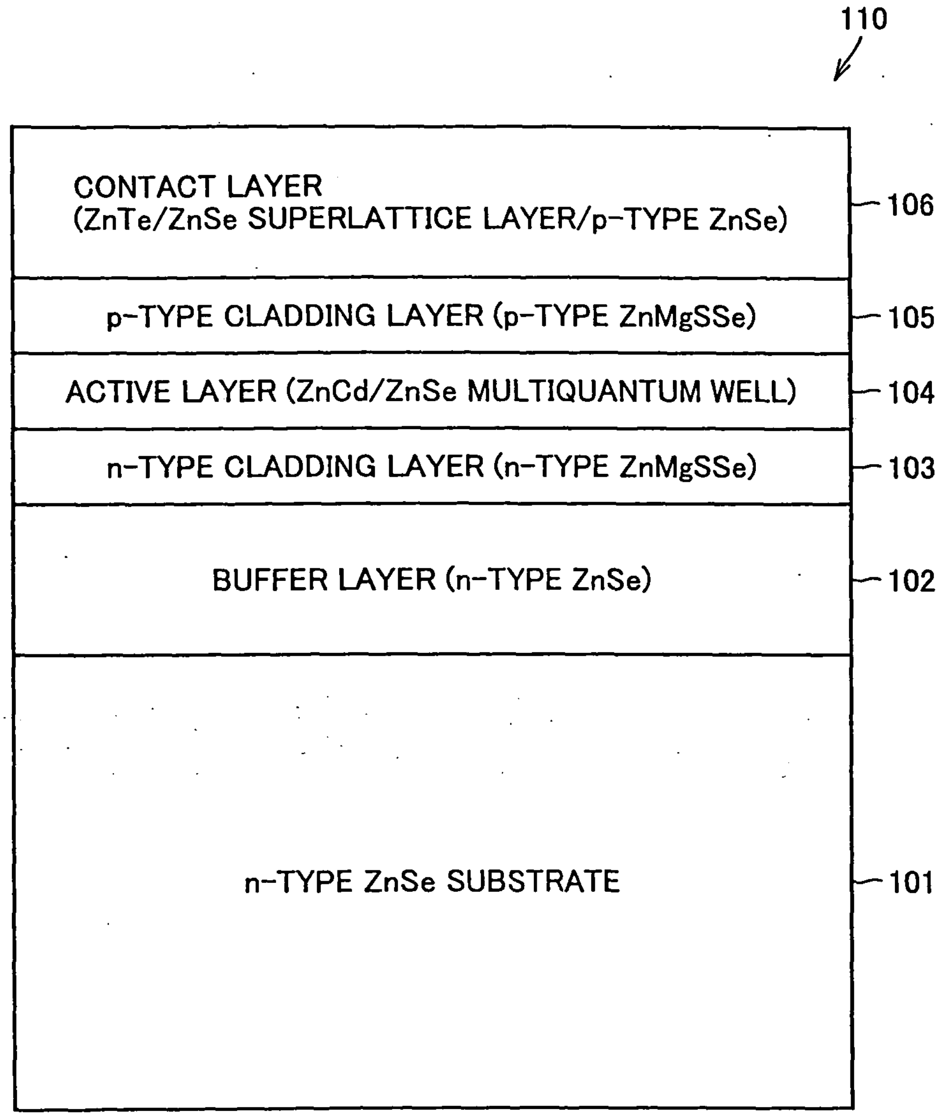
110
CONTACT LAYER
(ZnTe/ZnSe SUPERLATTICE LAYER/p-TYPE ZnSe)
106
p-TYPE CLADDING LAYER (p-TYPE ZnMgSSe)
105
ACTIVE LAYER (ZnCd/ZnSe MULTIQUANTUM WELL)
104
n-TYPE CLADDING LAYER (n-TYPE ZnMgSSe)
103
BUFFER LAYER (n-TYPE ZnSe)
102
n-TYPE ZnSe SUBSTRATE
101

FIG.20

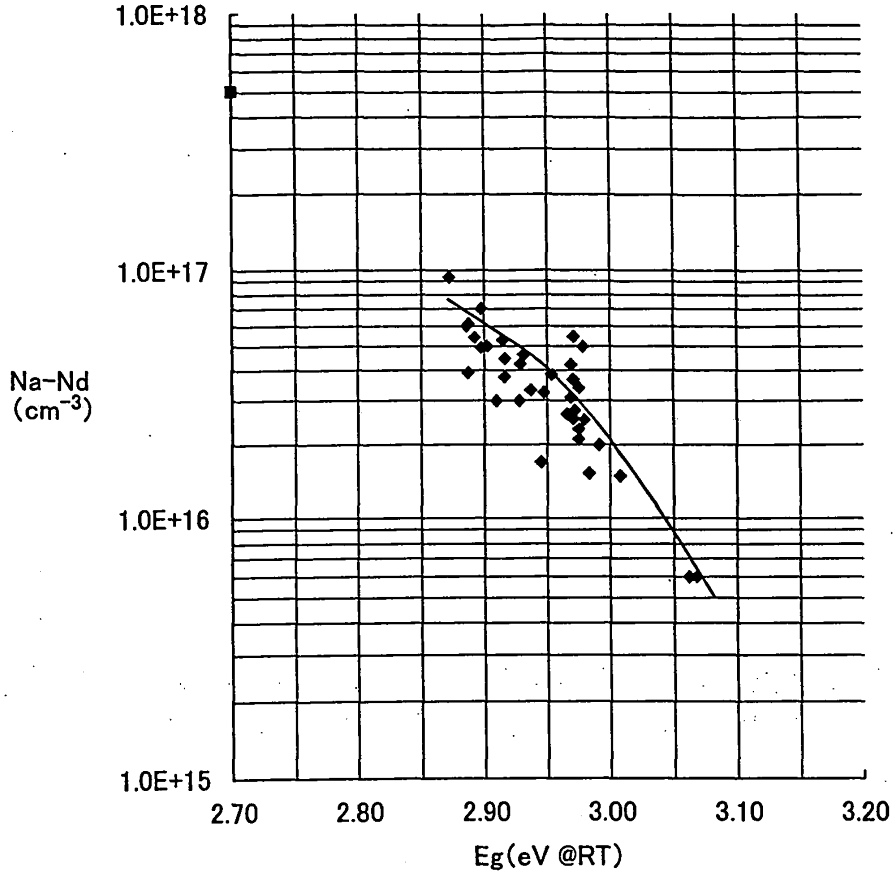
1.0E+18
1.0E+17
1.0E+16
1.0E+15
Na-Nd
(cm-3)
2.70
2.80
2.90
3.00
3.10
3.20
Eg(eV @RT)

FIG.21

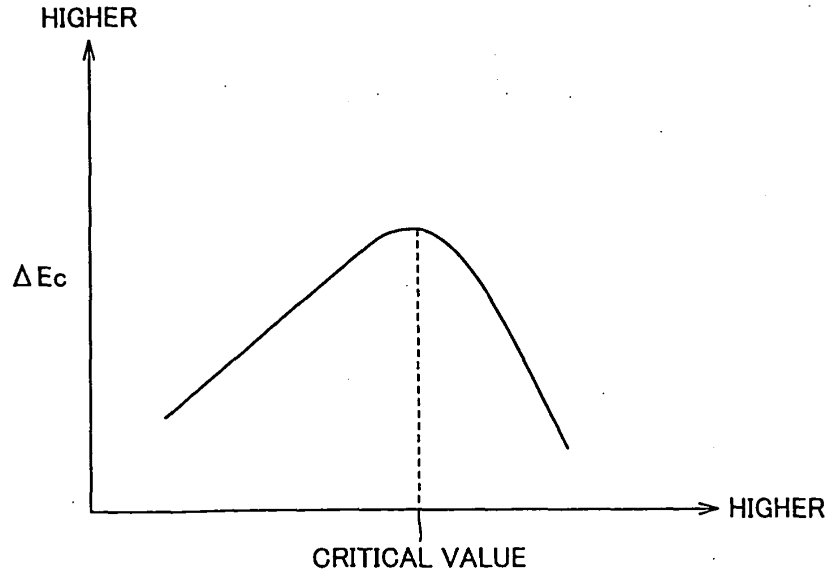
HIGHER
ΔEc
HIGHER
CRITICAL VALUE